(19) Europäisches Patentamt
European Patent Office
Office européen des brevets

(11) **EP 3 096 251 A1**

(12) **DEMANDE DE BREVET EUROPEEN**

(43) Date de publication:
**23.11.2016 Bulletin 2016/47**

(51) Int Cl.:
***G06F 17/50*** *(2006.01)*

(21) Numéro de dépôt: **16164162.6**

(22) Date de dépôt: **13.09.2010**

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **14.09.2009 FR 0956286**

(62) Numéro(s) de document de la (des) demande(s) initiale(s) en application de l'article 76 CBE:
**10766303.1 / 2 478 455**

(71) Demandeur: **AIRBUS OPERATIONS (S.A.S)**
**31060 Toulouse (FR)**

(72) Inventeurs:
• **COUDOUENT, Gérard**
**31470 FONTENILLES (FR)**
• **MESSINA, Paolo**
**31100 TOULOUSE (FR)**

(74) Mandataire: **Gicquel, Olivier Yves Gérard**
**Airbus Opérations (S.A.S.)**
**Intellectual Property Department**
**316, route de Bayonne**
**ETRT - M0101/1**
**31060 Toulouse Cedex 9 (FR)**

Remarques:
Cette demande a été déposée le 07.04.2016 comme demande divisionnaire de la demande mentionnée sous le code INID 62.

(54) **PROCÉDÉ D'ANALYSE STRUCTURALE DE PANNEAUX EN MATÉRIAU ISOTROPE DE TYPE RAIDIS PAR DES POCHES TRIANGULAIRES**

(57) La présente invention a pour but de proposer un procédé de dimensionnement de panneaux raidis par des poches triangulaires permettant de prendre en compte des spécificités aéronautiques et plus particulièrement les contraintes admissibles pour les différents types de flambage et les calculs de facteurs de réserve adaptés. Le procédé concerne le dimensionnement, par méthode analytique d'un panneau sensiblement plan en matériau homogène et isotrope, le panneau étant composé d'une peau renforcée par un ensemble (dit "grille") de trois faisceaux parallèles de raidisseurs intégrés au panneau, les poches déterminées sur la peau par ces familles de raidisseurs étant triangulaires, les raidisseurs étant en forme de lame, le panneau raidi devant satisfaire un cahier des charges de résistance mécanique à des charges externes prédéterminées, comportant des étapes agencées de façon à être répétées itérativement pour différentes valeurs de données d'entrée jusqu'à l'obtention de facteurs de réserve permettant de déterminer les dimensions et l'agencement des éléments du panneau afin d'obtenir la résistance mécanique imposée. La présente invention conduit à de nombreux avantages dont celui de pouvoir installer les panneaux ainsi obtenus en lieu et place de ceux précédemment réalisés.

Fig. 7

**Description**

La présente invention relève du domaine des structures. Il concerne en particulier les structures de type panneaux raidis, et encore plus particulièrement de tels panneaux, renforcés par des raidisseurs. L'invention s'intéresse au calcul de résistance de telles structures soumises à des charges combinées.

**Art antérieur et problème posé**

Les structures fines raidies représentent la plupart des structures primaires des aéronefs commerciaux.

Les panneaux sont généralement renforcés avec des raidisseurs perpendiculaires les uns aux autres et définissant des zones rectangulaires sur la peau du panneau, limitées par les raidisseurs, et appelées **poches**.

Une structure d'avion est ainsi conçue avec un squelette de raidisseurs et une peau :

-· des raidisseurs longitudinaux (généralement appelés longerons): ils permettent de soutenir la structure dans la direction principale des charges

-· des raidisseurs transversaux (généralement nommés "frame" ou "rib") : leur fonctionnalité principale est de fournir un support pour les longerons

-· un panneau (généralement nommé peau): en règle générale, il reprend le chargement dans le plan (membrane)

Les longerons et les lisses sont orientés à 90° les uns des autres et définissent sur la peau des poches rectangulaires.

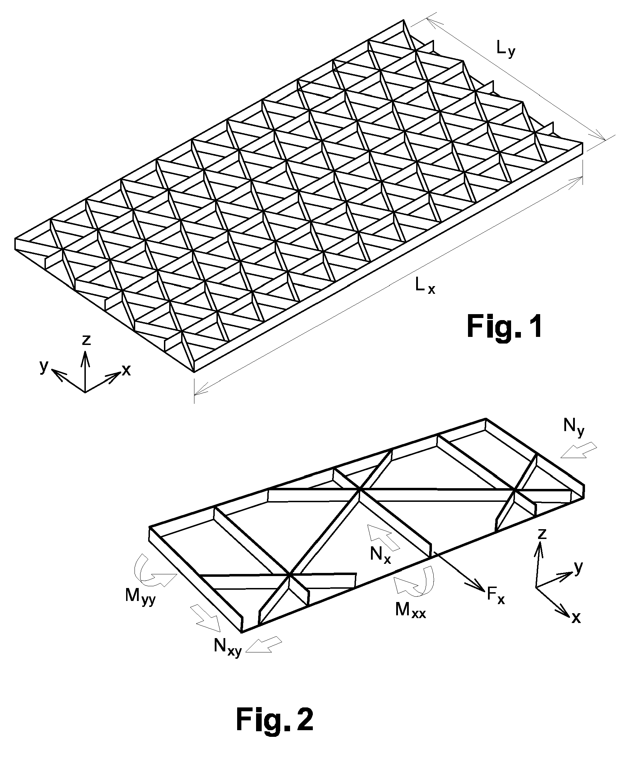

Cependant, dans les années 1950 et 60, pour les structures spatiales, la NASA a développé un nouveau concept de structure raidie appelée **"Isogrid"** (voir figure 1).

Une telle structure raidie est ainsi composée d'une peau renforcée avec un réseau de raidisseurs orientés à $\Theta°$ ($\Theta$ =60°, dans les structures envisagées par la NASA) entre eux. Les raidisseurs sont en forme de lame et sont intégrés au panneau. En raison de sa géométrie, cette configuration possède un comportement orthotrope (isotrope lorsque $\Theta$ = 60 °) et les poches formées sur la peau sont triangulaires.

On utilise dans la suite de la description les termes de **structure raidie par des poches triangulaires ou panneau raidi par des poches triangulaires** pour définir des structures ou panneaux renforcés par des raidisseurs croisés formant des poches triangulaires.

Des données limitées sont disponibles dans la littérature pour calculer la résistance et la stabilité d'une telle structure raidie par des poches triangulaires.

**Etat de l'art des méthodes de calcul de panneau raidis par des poches triangulaires**

Un procédé de calcul analytique de panneau raidi par des poches triangulaires équilatérales est décrit dans le document Rapport de Contrat NASA "Isogrid" design handbook" (NASA-CR-124075, 02/1973)

Cette méthode est bien documentée, mais présente de sérieuses limitations : utilisation de triangles équilatéraux uniquement : angle = 60°, calcul de contraintes appliquées mais pas de calcul de contraintes admissibles, coefficient de Poisson du matériau valant uniquement 1/3.

La méthode antérieure présente de nombreuses limitations et ne prend pas en compte tous les problèmes qui se présentent sur une structure d'aéronef, notamment en ce qui concerne les conditions aux limites et la plasticité. Elle n'est donc pas utilisable de façon fiable pour le calcul analytique de structure de panneaux raidis par des poches triangulaires

**Objectifs de l'invention**

Afin d'effectuer une analyse structurelle des panneaux raidis par des poches triangulaires, une méthode d'analyse structurale a été développée, basée sur une théorie de plaque composite et tenant compte de ses modes d'effondrement spécifiques. Cette méthode, s'applique aux panneaux plats réalisés dans un matériau à propriétés isotropes.

Le procédé décrit ici envisage une modification de l'angle de base entre les raidisseurs (qui est de 60 ° dans les structures "Isogrid"). Cela signifie que l'isotropie du panneau est n'est plus garantie.

**Exposé de l'invention**

L'invention vise à cet effet un procédé de dimensionnement par méthode analytique d'un panneau sensiblement plan en matériau homogène et isotrope, le panneau étant composé d'une peau renforcée par un ensemble (dit "grille") de trois faisceaux parallèles de raidisseurs intégrés au panneau, les poches déterminées sur la peau par ces familles de raidisseurs étant triangulaires, les raidisseurs étant en forme de lame, le panneau raidi devant satisfaire un cahier des charges de résistance mécanique à des charges externes prédéterminées,

les angles entre faisceaux de raidisseurs étant tels que les poches triangulaires sont de forme isocèle quelconque.

Selon une mise en oeuvre avantageuse, le procédé comporte des étapes :

Etape 2 - de calcul des contraintes appliquées dans la peau et les raidisseurs, ainsi que de flux dans la peau et charges dans les raidisseurs, à partir de la géométrie du panneau raidi, et des charges externes, supposées situées dans le plan du panneau et appliquées au centre de gravité de la section (du panneau), le panneau raidi étant représenté par un assemblage de deux plaques orthotropes, la grille de raidisseurs étant représentée par un panneau équivalent.

Etape 3 - de calcul des charges internes dans le panneau raidi,

Etape 4 - d'analyse de résistance comportant un calcul des facteurs de réserve du matériau à charge limite et à charge ultime,

Etape 5 - de calcul de contraintes locales admissibles,

Préférentiellement, le procédé prend en compte la redistribution des contraintes appliquées entre le panneau et la grille de raidisseurs due :

au post-flambage des raidisseurs, par la définition d'une section droite efficace pour chaque type de raidisseur ($0°$, $+\theta$ or $-\theta$) : $A_{0°}^{st}$, $A_{+\theta}^{st}$ et $A_{-\theta}^{st}$,

au post-flambage de la poche à travers le calcul d'une épaisseur efficace du panneau : $t_{s\_eff}$,

à la plasticité des charges externes appliquées, grâce à un procédé itératif sur les différentes propriétés du matériau, notamment modules d'Young et coefficients de Poisson : $E_{0°}^{st}$, $E_{+\theta}^{st}$, $E_{-\theta}^{st}$ pour les raidisseurs et $E_x^s$, $E_y^s$ et $v_{ep}^{st}$ pour la peau, utilisant la loi de Ramberg - Osgood.

Selon un mode préféré de mise en oeuvre du procédé selon l'invention, celui-ci comporte une étape de correction des charges appliquées pour tenir compte de la plasticité, utilisant un procédé de calcul itératif de contraintes plastiques, réalisé jusqu'à ce que les cinq paramètres du matériau ($E_{0°}^{st}$, $E_{+\theta}^{st}$, $E_{-\theta}^{st}$, $E_{peau}$, $v_{ep}$) entrés au début du processus soient sensiblement égaux aux mêmes paramètres obtenus après calcul de contrainte plastique.

Selon une mise en oeuvre avantageuse, le procédé comporte une étape 4, d'analyse de résistance comportant un calcul des facteurs de réserve du matériau à charge limite et à charge ultime, réalisée par comparaison des charges appliquées calculées dans les composants du panneau raidi, et des contraintes maximums admissibles du matériau, les charges appliquées étant corrigées pour tenir compte de la plasticité du panneau raidi.

Selon une mise en oeuvre avantageuse, le procédé comporte une étape 5 de calcul de contraintes locales admissibles, laquelle comporte une sous-étape 5A de calcul de flux de flambage admissible, et de facteur de réserve pour des poches triangulaires isocèles, les contraintes appliquées à prendre en compte pour le calcul de facteur de réserve étant les contraintes agissant dans la peau uniquement, les flux externes utilisés étant des flux de peau ne correspondant pas au chargement complet du panneau raidi.

Dans ce cas, l'étape 5A de calcul de flux de flambage admissible, et de facteur de réserve pour des poches triangulaires isocèles comporte favorablement deux sous-étapes : d'abord de calcul de valeurs admissibles pour des plaques soumises à des cas de chargement pur (compression selon deux directions dans le plan, cisaillement) en utilisant une méthode par éléments finis, puis de calcul des courbes d'interaction entre ces cas de chargement pur.

Encore plus précisément, le calcul de valeurs admissibles comporte des sous-étapes suivantes :

• Création d'un modèle paramétrique FEM d'une plaque triangulaire
• Exécution de nombreuses combinaisons différentes pour obtenir des résultats de flambage,
• Obtention de paramètres compatible avec une formulation analytique polynomiale.

Dans un mode particulier de mise en oeuvre, dans le cas d'un chargement pur, les courbes d'interaction sont définies par des sous-étapes suivantes :

- de création de modèles éléments finis d'une pluralité de plaques triangulaires présentant des angles isocèles différents, l'angle isocèle ($\theta$) étant défini comme l'angle de base du triangle isocèle,
- pour chaque angle isocèle :

1/ de calcul par Modèle Eléments Finis pour déterminer le flux admissible de plissement (sans correction plastique) pour diverses épaisseurs de plaque.

2/ de tracé d'une courbe de flux de flambage admissible en fonction du rapport $\dfrac{D}{h^2}$ (D raideur de plaque, $h$ hauteur du triangle), cette courbe étant déterminée pour des petites valeurs du rapport $\dfrac{D}{h^2}$ , par une équation au second degré fonction de ce rapport, dont les coefficients $K_1$ et $K_2$ dépendent de l'angle et du cas de charge considéré,

3/ de tracé de l'évolution des coefficients de l'équation polynomiale $K_1$ et $K_2$ en fonction de l'angle de base du triangle isocèle, ces coefficients étant tracés en fonction de l'angle des plaques triangulaires considérées, et d'interpolation pour déterminer une équation polynomiale qui permet de calculer ces constantes quel que soit l'angle isocèle.

Toujours dans le cas de calcul de flux de flambage admissible, et de facteur de réserve pour des poches triangulaires isocèles, selon une mise en oeuvre avantageuse, dans le cas d'un chargement combiné, on utilise l'hypothèse suivante : si certains composants de la charge combinée sont en tension, alors ces composants ne sont pas pris en compte pour le calcul, et les courbes d'interaction sont définies par des sous-étapes suivantes :

- de création de modèles éléments finis d'une pluralité de plaques triangulaires présentant des angles isocèles dif-férents, l'angle isocèle ($\theta$) étant défini comme l'angle de base du triangle isocèle,
- pour chaque angle,

1/ de calcul par Modèle Eléments Finis (FEM) pour déterminer la valeur propre de flambage correspondant à différentes répartitions de charges externes.

2/ de tracé des courbes d'interaction, pour chaque angle et chaque combinaison de charges, puis d'approximation de ces courbes avec une unique équation couvrant toutes les combinaisons :

$$R_{cX}{}^A + R_{cY}{}^B + R_s{}^C = 1 \ (\text{où} \ R_i = \frac{N_i{}^{app}}{N_i{}^{crit}} \ , \ \text{équations dans lesquelles } R_i \text{ représente le taux de charge et}$$

$N_i{}^{app}$ et $N_i{}^{crit}$ les flux appliqués et flux critiques pour i = cX, cY ou s, correspondant à des cas de compression selon les axes X et Y, et à un cas de cisaillement), A, B, C étant des coefficients empiriques.

Avantageusement, le procédé comporte en outre une sous-étape de calcul de facteurs de réserve, par résolution de l'équation suivante :

$$\left(\frac{R_{cY}}{R}\right)^A + \left(\frac{R_{cX}}{R}\right)^B + \left(\frac{R_s}{R}\right)^C = 1$$

avec $R = \dfrac{N_{cY}{}^{app}}{N_{cYcomb}{}^{crit}} = \dfrac{N_{cX}{}^{app}}{N_{cXcomb}{}^{crit}} = \dfrac{N_s{}^{app}}{N_{scomb}{}^{crit}} = \dfrac{1}{RF}$

Selon une mise en oeuvre avantageuse, le procédé utilise, pour le calcul des contraintes admissibles corrigées de plasticité, un facteur de correction de plasticité $\eta$, défini par :

- pour tous les cas de chargement (pur et combiné) à l'exception du cisaillement,

$$\eta_5 = \frac{E_{\tan}}{E_c}$$

- pour les cas de chargement en cisaillement pur,:

$$\eta_6 = \frac{(1+v_e)}{(1+v)} \cdot \frac{E_{\text{sec}}}{E_c}$$

la correction de plasticité étant calculée en utilisant la contrainte élastique équivalente de Von Mises.

Selon une mise en oeuvre avantageuse, dans le cas de plaques triangulaires isocèles en appui simple ou encastrées, en cas de chargement combiné, on utilise une courbe d'interaction : $R_{cX} + R_{cY} + R_s^{\frac{3}{2}} = 1$, pour tous les cas de chargement.

Selon une mise en oeuvre avantageuse, le procédé comporte une étape 5 de calcul de contraintes locales admissibles, laquelle comporte une sous-étape 5B de calcul de contrainte de flambage admissible et de facteur de réserve de l'âme du raidisseur, considéré comme un panneau rectangulaire, les contraintes appliquées pour les calculs de facteur de réserve étant les contraintes dans les âmes des raidisseurs seulement.

Selon une mise en oeuvre avantageuse du procédé, celui-ci comporte une étape 6, de calcul d'instabilité générale, fournissant des données de flux admissible de flambage, et des facteurs de réserve, pour un panneau plat raidi, dans des conditions de chargement pur ou combiné, les flux appliqués, à prendre en compte pour le calcul de facteur de réserve, étant les flux externes du panneau raidi.

Dans ce cas, plus précisément, le procédé comporte avantageusement des sous-étapes :

- d'utilisation d'une loi de comportement générale (équation 6-8), définissant les relations entre flux et moments, d'une part, et déformations, d'autre part, un état de contraintes plan étant considéré,
- d'utilisation d'équations d'équilibre général (équations 6-9 et 6-10) d'un élément du panneau raidi, reliant les flux, moments et la densité de forces de surface,
- de résolution d'une équation différentielle générale (équation 6-17) entre les flux de contraintes, la densité de forces de surface, les déplacements et les raideurs de flexion.

Selon une mise en oeuvre favorable, le procédé comporte une étape d'itération, permettant de modifier les valeurs de charges appliquées, ou les valeurs dimensionnelles des panneaux, selon les résultats de l'une au moins des étapes 3 à 6.

L'invention vise sous un autre aspect un produit-programme d'ordinateur comportant une série d'instructions adaptées à mettre en oeuvre un procédé tel qu'exposé, lorsque cette suite d'instructions est exécutée sur un ordinateur.

## Brève description des figures

La description qui va suivre, donnée uniquement à titre d'exemple d'un mode de réalisation de l'invention, est faite en se référant aux figures annexées qui représentent :

Figure 1 - Exemple d'un panneau plat raidi par des poches triangulaires,
Figure 2 - Définition du chargement et du système de coordonnées,
Figure 3 - Définition géométrique d'un panneau
Figure 4 - Noeud dans une structure raidie par des poches triangulaires,
Figure 5 - Exemple d'instabilité générale d'un panneau raidi par des poches triangulaires,
Figure 6 - Théorie de la largeur efficace,
Figure 7 - Organigramme général du procédé selon l'invention,
Figure 8 - Décomposition de la grille en triangles élémentaires,
Figure 9 - Triangle isocèle élémentaire utilisé dans le calcul de masse du panneau,
Figure 10 - Triangle rectangle élémentaire utilisé dans le calcul de masse du panneau,
Figure 11 - Forme élémentaire de grille de raidisseurs dans un panneau raidi par des poches triangulaires,
Figure 12 - Cas de chargements purs de la plaque raidie,
Figure 13 - Schématisation de charges sur un raidisseur,
Figure 14 - Expression des coefficients Kc en fonction des cas de conditions aux limites,
Figure 15 - Panneau de raidisseurs considéré comme assemblage de deux plaques orthotropes,
Figure 16 - Charges sur une forme élémentaire de grille de raidisseurs pour panneau raidi par des poches triangulaires,
Figure 17 - Procédé de calcul de charges appliquées corrigées de la plasticité,

Figure 18 - Conventions de notation du triangle isocèle élémentaire,

Figure 19 - Interpolation linéaire ou quadratique du coefficient K,

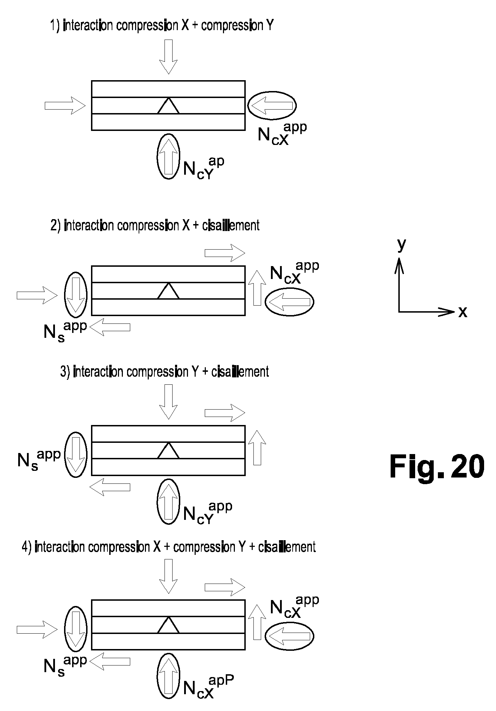

Figure 20 - Cas de chargement combiné,

Figure 21 - Conventions de flux et moments,

Figure 22 - Valeur de $h(\overline{\alpha})$ en fonction des différentes conditions aux limites, pour un cas de compression,

Figure 23 - Coefficient de flambage en cisaillement pour une configuration à quatre bords en appui simple,

Figure 24 - Tableau de valeurs du coefficient de flambage en cisaillement,

Figure 25 - Coefficient de flambage en cisaillement pour une configuration à quatre bords encastrés,

Figure 26 - Evolution de la constante K1 selon l'angle isocèle pour une plaque triangulaire en appui simple,

Figure 27 - Evolution de la constante K2 selon l'angle isocèle pour une plaque triangulaire en appui simple,

Figure 28 - Evolution de la constante K1 selon l'angle isocèle pour une plaque triangulaire encastrée,

Figure 29 - Evolution de la constante K2 selon l'angle isocèle pour une plaque triangulaire encastrée.

## Description détaillée d'un mode de réalisation de l'invention

Le procédé d'analyse de résistance de panneau métallique raidi par des poches triangulaires, principalement plan, décrit est destiné à être mis en oeuvre sous forme de programme sur un ordinateur de type connu en soi.

Le procédé est destiné à être utilisé pour une structure principalement plane (raidisseurs et peau). Le procédé décrit ici s'applique exclusivement au calcul de paramètres structurels typiques ("typical structural settings") avec les limitations suivantes :

Les extrémités de la zone étudiée ne bordent pas d'ouverture.

Aucun raidisseur ne déborde de la zone étudiée.

Chaque coupe doit être limitée par des raidisseurs.

Toutes les poches triangulaires sur la peau sont supposées avoir la même épaisseur.

Tous les raidisseurs sont supposés de mêmes dimensions.

Ce procédé est utilisé pour calculer des panneaux construits à partir de matériau homogène et isotrope (par exemple mais non limitativement du métal) pour lequel les courbes monotones croissantes décrivant $(\sigma, \varepsilon)$ peuvent être idéalisées par le moyen de formules telles que R&O (voir plus loin).

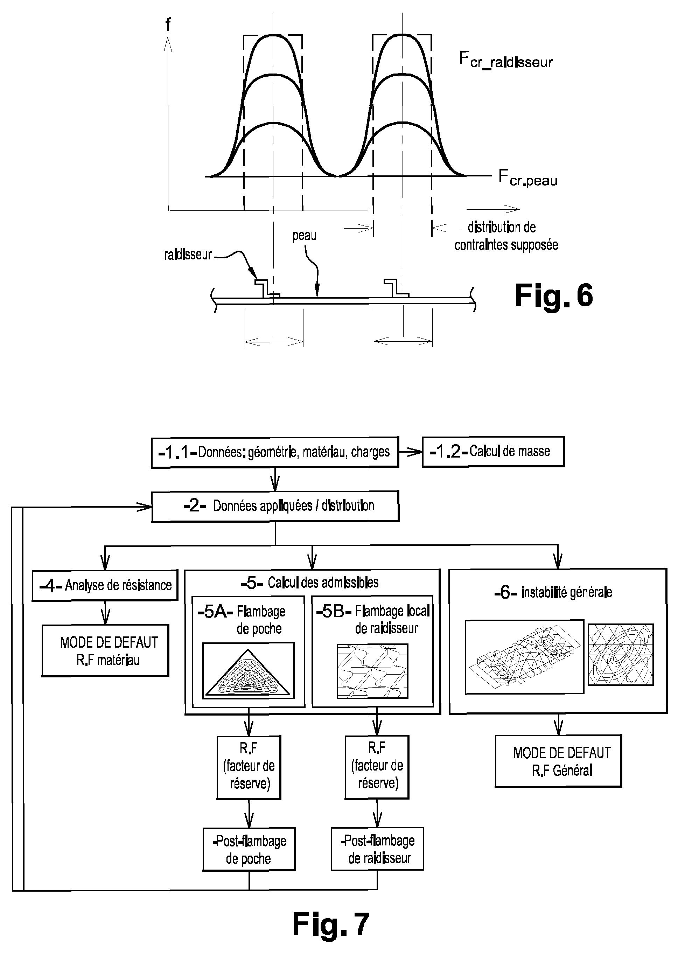

L'organigramme simplifié du procédé selon l'invention est illustré figure 7.

Deux types d'effondrements (dont la survenue est évaluée dans les étapes 4 et 6 du procédé) peuvent se produire sur une structure raidie par des poches triangulaires: une défaillance du matériau (qui fait l'objet de l'étape 4): les contraintes appliquées atteignent les contraintes maximums admissibles du matériau ($F_{tu}$ or $F_{su}$), effondrement global : un flambage général (comprenant la grille de raidisseurs) se produit sur la totalité du panneau (cette vérification fait l'objet de l'étape 6).

Par ailleurs, deux types d'instabilité (objet de l'étape 5) affaiblissent la raideur globale de la structure raidie par des poches triangulaires mais ne causent pas l'effondrement global de la structure complète :

Instabilité du panneau : flambage des poches triangulaires

Instabilité des raidisseurs : flambage des âmes des raidisseurs

Les parties flambées peuvent supporter seulement une partie de la charge qu'elles auraient supportée avant leur flambage. De ce fait, les charges appliquées sont redistribuées dans la structure.

On note que dans la présente invention, les calculs post-flambage ne sont pas traités. De ce fait, les deux types de flambage cités ci-dessus sont considérés comme des modes d'effondrement.

## Notation et Unités

Les conventions de notations et de systèmes d'axes sont explicitées dans la figure 2

Un système local de coordonnées est défini pour chaque raidisseur. Un axe X est défini dans le plan de la section droite du raidisseur, c'est l'axe sortant, dans la direction de la dimension principale du raidisseur. Un axe Z est défini comme l'axe normal au plan de la peau, dans la direction du raidisseur. Enfin, un axe Y est le troisième axe dans un système de coordonnées droit.

Pour les forces et charges, un signe négatif sur une force selon l'axe X signifie une compression du raidisseur, un signe positif signifie une tension.

Un moment de flexion positif induit une compression dans la peau et une tension dans les raidisseurs.

On utilise les notations générales définies dans le tableau suivant.

| Symbole | Unité | Description |
|---------|-------|-------------|
| A | $mm^2$ | Surface |
| J | $mm^4$ | Inertie |
| J | $mm^4$ | Constante de torsion |
| K | $N/mm$ | Raideur normale (tension/compression) d'une plaque |
| D | $N.mm$ | Rigidité de flexion ("bending" en anglais) d'une plaque |
| σ | $N/mm^2$ | Contrainte ("stress" en anglais) |
| ε | - | Déformation ("strain" en anglais) |
| $K$ | - | Déformation hors du plan |
| 11 | - | Facteur de correction plastique |
| z | $mm$ | Coordonnée sur l'axe z |
| k | - | Coefficient de flambage |

Suffixes:

| Symbole | Unité | Description |
|---------|-------|-------------|
| g | - | grille |
| st | - | raidisseur |
| s | - | peau |

**Caractéristiques géométriques**

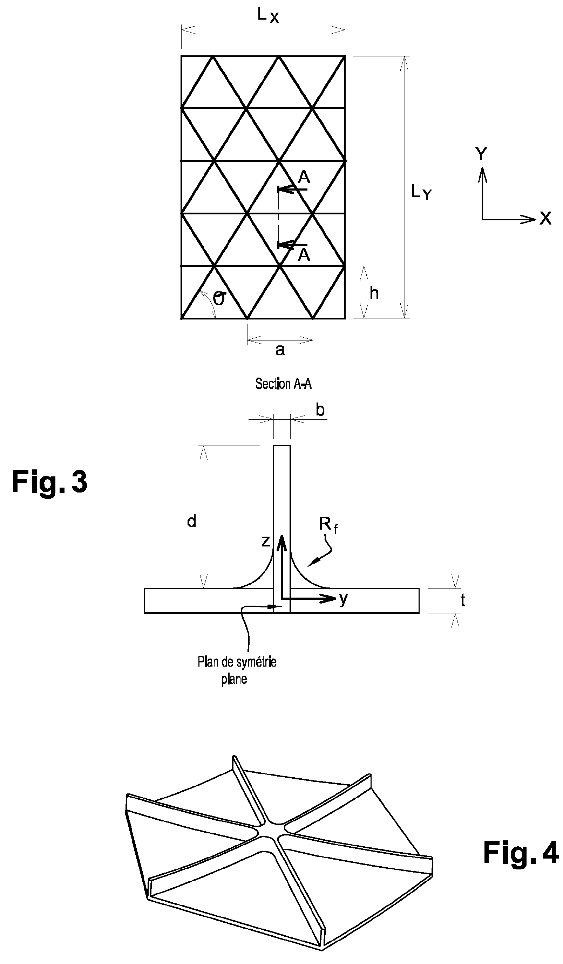

Les caractéristiques géométriques d'un panneau considéré ici à titre d'exemple nullement limitatif sont donnés figure 3.

Pour la suite de la description, on utilise plusieurs hypothèses. On suppose que l'axe Z est un plan de symétrie pour la section droite d'un raidisseur. De même, les dimensions a et h sont définies à propos de la fibre neutre d'un raidisseur. Par ailleurs, le panneau raidi par des poches triangulaires envisagé n'a pas de raidisseurs aux deux bords définis par : X=0 et X=Lx

| Symbole | Unité | Description |
|---------|-------|-------------|
| $L_x$ | $mm$ | longueur |
| $L_Y$ | $mm$ | largeur |
| a | $mm$ | Longueur du côté d'un triangle |
| θ | ° | Angle du triangle |
| h | $mm$ | Hauteur d'un triangle $\left( = \dfrac{a}{2} \cdot \tan\theta \right)$ |
| t | $mm$ | Epaisseur de la peau |
| d | $mm$ | Hauteur de la toile de raidisseurs |
| b | $mm$ | Épaisseur de la toile de raidisseurs |
| $R_n$ | $mm$ | Rayon de filet de noeud |
| $R_f$ | $mm$ | Rayon de poche |
| $A_{x°}^{st}$ | $mm^2$ | Section droite du raidisseur selon l'axe x |

(suite)

| Symbole | Unité | Description |
|---------|-------|-------------|
| $v_p$ | *mm* | Décalage ("offset") du panneau entre son centre de gravité et le point d'origine du système local de coordonnées |
| $v_w$ | *mm* | Décalage du réseau de raidisseurs entre son centre de gravité et le point d'origine du système local de coordonnées |

**Matériaux**

| Symbole | Unité | Designation |
|---------|-------|-------------|
| $F_{cy}$ | *MPa* | Limite élastique du matériau en compression |
| $F_{tu}$ | *MPa* | Résistance de tension ultime du matériau |
| $F_{su}$ | *MPa* | Résistance de cisaillement ultime du matériau |
| $\sigma_n$ | *MPa* | Contrainte de référence |
| $\varepsilon_{ult}$ | - | Déformation ("strain") plastique ultime (=e%) |
| $v_e$ | - | Coefficient de Poisson élastique |
| $v_p$ | - | Coefficient de Poisson plastique (= 0.5) |
| $v$ | - | Coefficient de Poisson élasto-plastique |
| $E_c$ | *MPa* | Module d'Young élastique en compression |
| $E$ | *MPa* | Module d'Young élastique en tension |
| Esec | *MPa* | Module sécant |
| $E_{tan}$ | *MPa* | Module Tangent |
| $n_{ec}$ | - | Coefficient de Ramberg et Osgood (R&O) en compression |
| $G$ | *MPa* | Module de cisaillement |
| $G_{sec}$ | *MPa* | Module de cisaillement sécant |
| $\rho$ | *kg/mm³* | Densité du matériau |

**Contraintes**

| Symbol | Unité | Désignation |
|--------|-------|-------------|
| $P_i$ | *N* | Charge normale avec i égal à :<br>• 0° pour la charge appliquée sur un raidisseur à 0°<br>• x° pour la charge appliquée sur un raidisseur à x° |
| N | *N/mm* | Flux |
| M | *N.mm* | Moment de flexion |
| $\tau$ | *MPa* | Contrainte de cisaillement |
| $\sigma$ | *MPa* | Contrainte normale |
|  | *MPa* | Contrainte de flambage d'un panneau i en compression |
|  | *MPa* | Contrainte de flambage d'un panneau i en cisaillement |
| $\sigma_{app}^i$ | *MPa* | Contraintes appliquées sur l'élément i |
| RF | - | Facteur de réserve |

(suite)

| Symbol | Unité | Désignation |
|---|---|---|
| $R_c$ | - | Taux de charge en compression |
| $R_s$ | - | Taux de charge en cisaillement |
| $R_p$ | - | Taux de charge dû à la pression |
| LL | | Charge limite |
| UL | | Charge ultime |

**Définitions**

On définit pour la suite de la description les termes suivants.

Dans une structure raidie par des poches triangulaires, on appelle **grille** le réseau complet de raidisseurs seuls

On définit de même un **noeud** est une intersection de plusieurs raidisseurs dans une structure raidie par des poches triangulaires (voir figure 4). En pratique, il s'agit d'un élément au design complexe comportant des rayons de courbure dans les deux directions.

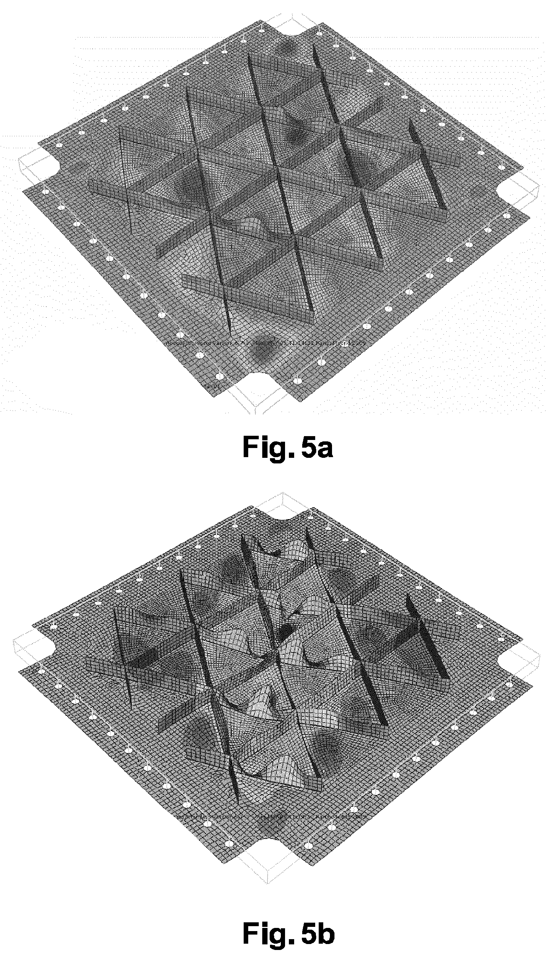

Quand une structure (soumise uniquement à des charges dans son plan) subit des déplacements visibles significatifs transversaux au plan des charges, elle est dite en **flambage** ("buckle" en langue anglo-saxonne). La figure 5a illustre un tel cas d'instabilité locale de panneau raidi par des poches triangulaires.

Le phénomène de flambage peut être mis en évidence en pressant les cotés opposés d'un feuille plane de carton l'un vers l'autre. Pour de petites charges, le flambage est élastique (réversible) puisque le flambage disparaît lorsque la charge est supprimée.

**Un flambage local (**ou **instabilité locale**) de plaques ou coques ("shells") est indiqué par l'apparition de bosses, ondulations ou vagues et est couramment rencontré pour les plaques composants des structures minces. Lorsqu'on considère des panneaux raidis, un flambage local, par opposition au flambage général, décrit une instabilité dans laquelle le panneau entre les longerons (raidisseurs) flambe, mais les raidisseurs continuent à soutenir les panneaux et ne montrent pas de déformation significative hors du plan.

La structure peut alors présenter deux états d'équilibre :

- Stable : dans ce cas les déplacements augmentent de façon contrôlée lorsque les charges augmentent, c'est-à-dire que la capacité de la structure à supporter des charges supplémentaires est maintenue, ou

- Instable : dans ce cas, les déformations augmentent instantanément, la capacité à supporter des charges diminue rapidement

Un équilibre neutre est également possible en théorie durant le flambage, cet état est caractérisé par une augmentation de la déformation sans modification de la charge

Si les déformations de flambage deviennent trop grandes, la structure s'effondre ("fails" en langue anglo-saxonne). Si un composant ou une partie d'un composant risque de subir un flambage, alors sa conception doit satisfaire à la fois les contraintes de résistance et de flambage.

On nomme **instabilité générale** le phénomène qui apparaît lorsque les raidisseurs ne sont plus capables de contrecarrer les déplacements du panneau hors du plan lors du flambage.

La figure 5b montre un exemple de flambage global en compression d'une structure raidie par des poches triangulaires, lorsque le panneau atteint son premier mode de flambage général.

De ce fait, il est nécessaire de vérifier si les raidisseurs agissent comme de simples supports du panneau (en compression, en cisaillement, et en combinaison). Si cette condition n'est pas remplie, on doit supposer que l'assemblage du panneau et des raidisseurs flambe de façon globale dans un mode d'instabilité, ce qui doit être évité dans une structure destinée à un usage aéronautique.

Un **effondrement général** (ou global) se produit lorsque la structure n'est plus capable de supporter de charge supplémentaire. On dit alors que la structure a atteint la charge d'effondrement ("failure loading" en langue anglo-saxonne) ou la charge maximale admissible ("loading capacity" en langue anglo-saxonne)

L'effondrement général couvre tous les types d'effondrement :

- Effondrement dû à une instabilité (instabilité générale, post-flambage...)

- Effondrement dû au dépassement de la charge maximum supportable par le matériau (par exemple après un flambage local)

La **largeur efficace** (ou **largeur travaillante**) de la peau d'un panneau est définie comme la portion de la peau supportée par un longeron dans une structure de panneau raidi qui ne flambe pas lorsqu'elle est soumise à une charge de compression axiale.

Le flambage de la peau seule ne constitue pas un effondrement du panneau; en fait, le panneau va supporter des charges additionnelles jusqu'à la contrainte pour laquelle la colonne formée par le raidisseur et le panneau efficace ("effective panel") commence à être détruite ("fail"). Lorsque la contrainte dans le raidisseur augmente au delà de la contrainte de flambage de la peau, la peau adjacente au raidisseur supporte une contrainte additionnelle du fait du support fourni par les raidisseurs. Cependant, la contrainte au centre du panneau ne dépassera pas la contrainte initiale de flambage, quel que soit la contrainte atteinte au niveau du raidisseur.

La peau est plus efficace autour de la position des raidisseurs parce qu'il existe localement un support contre le flambage. A un niveau de contrainte donné, inférieur au flambage local de la peau, la largeur efficace est égale à la largeur du panneau. La théorie de la largeur efficace est illustrée par la figure 6

**Idéalisation du matériau**

On rappelle ici que jusqu'à la contrainte de limite élastique ("yield stress" en langue anglaise) ($F_{cy}$), la **courbe contrainte-déformation** ("stress-strain curve" en langue anglaise) du matériau est idéalisée par la loi connue de Ramberg et Osgood (dite "formule R&O" dans la suite de la description) :

$$\varepsilon = \frac{\sigma}{E_c} + 0.002 \cdot \left(\frac{\sigma}{Fcy}\right)^{n_c} \qquad \textbf{Equation 0-1}$$

On en déduit les expressions suivantes:

Module sécant:

$$E_{\sec} = \frac{\sigma}{\varepsilon} \xrightarrow{\text{R\&O law}} E_{\sec} = \frac{1}{\dfrac{1}{E_c} + \dfrac{0.002}{F_{cy}} \cdot \left(\dfrac{\sigma}{F_{cy}}\right)^{(n_c - 1)}} \qquad \textbf{Equation 0-2}$$

Module tangent:

$$\frac{1}{E_{\tan}} = \frac{\partial(\varepsilon)}{\partial(\sigma)} = \frac{n_c}{E_{\sec}} + \frac{1 - n_c}{E_c} \xrightarrow{\text{R\&O law}} E_{\tan} = \frac{1}{\dfrac{1}{E_c} + \dfrac{0.002}{F_{cy}} \cdot n_c \cdot \left(\dfrac{\sigma}{F_{cy}}\right)^{(n_c - 1)}}$$

$$\textbf{Equation 0-3}$$

Coefficient de Poisson:

$$\nu = \frac{E_{\sec}}{E_c} \cdot \nu_e + \left(1 - \frac{E_{\sec}}{E_c}\right) \cdot \nu_p \quad \text{Avec } \nu_p = 0.5$$

$$\textbf{Equation 0-4}$$

Il est à noter que, avec le rapport de R&O (paramètre *n* ou *n* corrigé), connu de l'homme de l'art, ces équations sont correctes uniquement dans la zone [0 ; $F_{cy}$]. Pour la suite de cette étude, cette zone doit être étendue de $F_{cy}$ à $F_{tu}$.

Au delà de $F_{cy}$, différentes courbes peuvent être utilisées jusqu'à la contrainte ultime, notamment : formule de R&O utilisant un coefficient n modifié, ou méthode elliptique.

Dans la suite, la formule de R&O utilise un coefficient modifié. La continuité entre les deux courbes est maintenue. Le coefficient n modifié de la formule R&O est calculé par :

$$n = \frac{\ln\left(\dfrac{\varepsilon_{2p}}{\varepsilon_{1p}}\right)}{\ln\left(\dfrac{\sigma_2}{\sigma_1}\right)}$$

**Equation 0-5**

Avec :

$$\varepsilon_{2p} = \varepsilon_{ult}$$

$$\varepsilon_{1p} = 0.002$$

$$\sigma_2 = F_{tu}$$

$$\sigma_1 = F_{cy}$$

Il est à noter que pour utiliser cette formule, les critères suivants doivent être respectés : $F_{tu} > F_{cy}$ et $\varepsilon_{ult} > 0.002$

Dans la méthode elliptique, au dessus de $F_{cy}$, une autre courbe est utilisée jusqu'à la contrainte ("stress") ultime: la courbe d'extension elliptique. Naturellement, la continuité entre la courbe de R&O et la courbe d'extension elliptique est assurée.

Les relations contrainte-déformation de l'extension elliptique sont :

$$\varepsilon_E(\sigma) = \varepsilon_3 - a\sqrt{1 - \frac{(\sigma - \sigma_{E\_ref} + b)^2}{b^2}} \quad ; \quad \sigma_E(\varepsilon) = \sigma_{E\_ref} - b + b\sqrt{1 - \frac{(\varepsilon - \varepsilon_3)^2}{a^2}}$$

**Equation 0-6**

avec:

$$a = \sqrt{\frac{-b^2 \cdot x_1}{m \cdot (b - D)}} \quad ; \quad b = \frac{D \cdot (m \cdot x_1 + D)}{m \cdot x_1 + 2D} \qquad \text{– ellipse parameters}$$

$$x_1 = \varepsilon_2 - \varepsilon_3 \; ; \; D = \sigma_{E\_ref} - \sigma_{RO\_ref} \; ; \; m = \frac{E}{1 + \varepsilon_{RO\_ref} \cdot \dfrac{nE}{\sigma_{RO\_ref}}}$$

**Plasticité**

Toujours à titre de rappel, il est connu que les facteurs de correction de plasticité dépendent du type de chargement et des conditions aux limites.

Les facteurs de correction de plasticité pour des panneaux rectangulaires plats sont présentés dans la table 1 ci-dessous.

| Chargement | Conditions aux limites | Equation |
|---|---|---|
| **Compression et flexion** | Bride ("flange") avec un bord charnière ("hinged") non chargé (bords appuyés-libres) | $\eta_1 = \dfrac{E_{sec}}{E_c} \cdot \dfrac{1 - v_e^2}{1 - v^2}$ |
| | Bride avec un bord fixe non chargé (encastré - bords libres) | $\eta_2 = \eta_1 \cdot \left( 0.33 + 0.335 \cdot \sqrt{1 + 3 \cdot \dfrac{E_{tan}}{E_{sec}}} \right)$ |
| | Plaque avec bords charnières ("hinged") non chargés (bords appuyés) | $\eta_3 = \eta_1 \cdot \left( 0.5 + 0.25 \sqrt{1 + 3\dfrac{E_{tan}}{E_{sec}}} \right)$ |
| | Plaque avec bords fixes non chargés (bords encastrés) | $\eta_4 = \eta_1 \cdot \left( 0.352 + 0.324 \sqrt{1 + 3\dfrac{E_{tan}}{E_{sec}}} \right)$ |
| **Compression** | Colonne | $\eta_5 = \dfrac{E_{tan}}{E_c}$ |
| **Cisaillement** | toutes conditions $\sigma_{eq} = \tau \cdot \sqrt{3}$ | $\eta_6 = \dfrac{G_{sec}}{G}$ |
| **Cisaillement** | bords retendus $\sigma_{eq} = \tau \cdot 2$ | $\eta_8 = \eta_1 \left( 0.83 + 0.17 \dfrac{E_{tan}}{E_{sec}} \right)$ |

Dans le cas particulier du cisaillement, la courbe contrainte-déformation de compression du matériau est également utilisée comme suit :

- Calcul de la contrainte normale équivalente : $\sigma_{eq} = \tau \cdot \sqrt{3}$

- Calcul des valeurs correspondantes E$_s$ et v à partir de cette contrainte : $\sigma_{eq}$

- $\eta_6 = \dfrac{G_s}{G} = \left( \dfrac{1 + v_e}{1 + v} \right) \cdot \dfrac{E_{sec}}{E_c} = \left( \dfrac{1 - v}{1 - v_e} \right) \cdot \eta_1$

**Etape 1 - Module d'entrée de données : géométrie, matériau, chargement**

Le procédé comporte une première phase, d'entrée des données relative au panneau raidi par des poches triangulaires considéré et au chargement appliqué à ce panneau. Ces données sont entrées par des moyens connus en soi et mémorisées dans des bases de données de type également connu.

Les paramètres d'entrée du procédé de calcul analytique de panneau raidi par des poches triangulaires, comportent notamment :

Dimensions générales : panneau rectangulaire (dimensions: $L_x$, $L_y$)
Section droite des raidisseurs : dimensions de l'âme : b, d Epaisseur constante du panneau (t)
Charges aux limites du panneau : $N_x$, $N_y$, $N_{xy}$

Calcul de masse

Cette partie est destinée au calcul de la masse du panneau raidi par des poches triangulaires complet, incluant la prise en compte des rayons de filet et de noeud. Cette étape de calcul de masse est indépendante du reste du procédé décrit ici. La masse est calculée de façon connue en soi à partir de la définition géométrique du panneau.

Les données d'entrée pour ce procédé sont la géométrie du panneau incluant les rayons des poches et des noeuds ($R_n$ et $R_f$). La donnée de sortie est la masse du panneau.

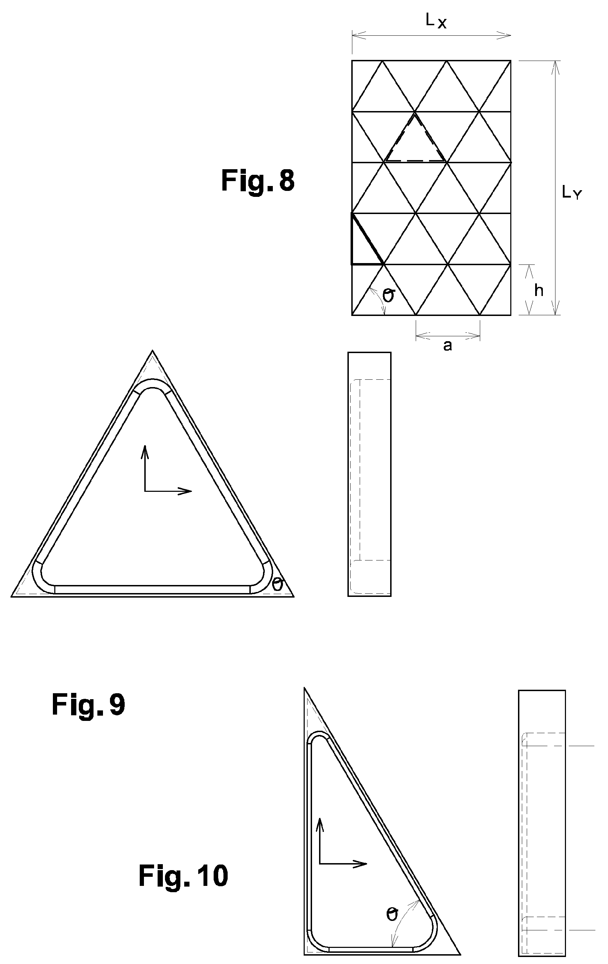

La masse est calculée en additionnant la masse de la peau et des longerons. Les rayons des filets entre deux longerons, et entre la peau et les longerons sont également pris en compte. Le calcul de masse est basé sur deux triangles élémentaires: triangle isocèle et triangle rectangle (voir figures 8, 9 et 10).

**Etape 2 - Calcul des charges appliquées**

Cette étape permet de calculer les contraintes appliquées dans la peau et les raidisseurs à partir de la géométrie du panneau raidi par des poches triangulaires, et des charges externes. La méthode prend en compte une correction de plasticité des charges appliquées, réalisée par un processus itératif. Elle permet de prendre en compte le post-flambage des raidisseurs et des poches.

Il s'agit d'un progrès substantiel vis à vis du NASA "Isogrid" design handbook" (NASA-CR-124075, 02/1973) en ce qu'il prend notamment en compte les points suivants : grille de raidisseurs avec $\theta \neq 60$, panneau raidi par des poches triangulaires considéré comme assemblage de deux plaques orthotropes.

Les données d'entrée de cette étape sont :

- Données géométriques :

  ∘ $\theta$ : angle de base du triangle,
  ∘ a : base du triangle,
  ∘ $A_i^{st}$: section droite du raidisseur, i = 0°, $\theta$ or - $\theta$.
  ∘ $t_s$ : épaisseur de la peau,
  ∘ $t_g$ : épaisseur du panneau équivalent à la grille

- Données sur le matériau :

  ∘ $E_x^s$, $E_y^s$ : module d'Young de la peau,
  ∘ $G_{xy}^s$ : module de cisaillement de la peau,
  ∘ $v_{xy}^s$, $v_{yx}^s$ : coefficient de Poisson de la peau,
  ∘ $E^{st}$: module d'Young des raidisseurs,
  ∘ $v^{st}$ : coefficient de Poisson des raidisseurs
  ∘ Données de matériau (n : coefficient de Ramberg & Osgood, Fcy, Ftu, $v_{plast}$=0.5)

- Charges appliquées à la structure ($N_x^0$, $N_y^0$, $N_{xy}^0$)

Les données obtenues en sortie de cette étape sont :

- $N_x^s$, $N_y^s$, $N_{xy}^s$ : flux dans la peau,
- $\sigma_x^s$, $\sigma_y^s$, $\tau_{xy}^s$ : contraintes dans la peau,
- $\sigma_{0°}$, $\sigma_\theta$, $\sigma_{-\theta}$ : contraintes dans les raidisseurs,
- $F_{0°}$, $F_\theta$, $F_{-\theta}$ : charges dans les raidisseurs.

Dans la suite de la description, la peau est supposée être un matériau isotrope.

Le procédé fournit des entrées pour :

o L'analyse de résistance (étape 4) : contraintes dans la peau et dans les raidisseurs
o l'analyse de flambage de poche (étape 5.1) : contraintes dans la peau
∘ l'analyse du flambage du raidisseur (étape 5.2) : contraintes dans les raidisseurs

∘ l'analyse d'instabilité générale (étape 6) : contraintes dans la peau et dans les raidisseurs pour calculer la raideur en flexion du panneau raidi par des poches triangulaires.

Le procédé de calcul nécessite des données d'entrée de post-flambage des raidisseurs: $\mathbf{A_{0°}^{st}}$ , $\mathbf{A_{+\theta}^{st}}$ et $\mathbf{A_{-\theta}^{st}}$ et de post-flambage des poches: $\mathbf{t_{s\_eff}}$

Le procédé prend en compte la redistribution des contraintes appliquées ("applied stresses") entre le panneau et la grille de raidisseurs due en premier lieu, au post-flambage des raidisseurs, par la définition d'une **section droite efficace** pour chaque type de raidisseur (0°, + θ or -θ): $\mathbf{A_{0°}^{st}}$, $\mathbf{A_{+\theta}^{st}}$ et $\mathbf{A_{-\theta}^{st}}$, en second lieu, au post-flambage de la poche à travers une épaisseur efficace du panneau : $\mathbf{t_{s\_eff}}$, enfin, à la plasticité des charges externes appliquées, grâce à un procédé itératif sur les différentes propriétés du matériau : $\mathbf{E_{0°}^{st}}$, $\mathbf{E_{+\theta}^{st}}$, $\mathbf{E_{-\theta}^{st}}$ pour les raidisseurs et $\mathbf{E_x^s}$, $\mathbf{E_y^s}$ et $\mathbf{v_{ep}^{st}}$ pour la peau.

La charge externe est supposée être dans le plan du panneau et appliquée au centre de gravité de la section :

$$\begin{Bmatrix} N \\ M \end{Bmatrix} = \begin{bmatrix} A & B \\ B & C \end{bmatrix} \cdot \begin{Bmatrix} \varepsilon \\ \kappa \end{Bmatrix}$$

donc : $\varepsilon \neq 0$ et $\kappa = 0 \rightarrow \{N\} = [A] \cdot \{\varepsilon\}$ avec $\{N\} = \begin{Bmatrix} Nx \\ Ny \\ Nxy \end{Bmatrix}$

En conséquence, les contraintes dans la peau ne sont pas fonction de l'épaisseur de ladite peau et de la position dans le plan. De même, les contraintes dans les raidisseurs ne sont pas fonction de la position sur la section du raidisseur, mais seulement de l'angle du raidisseur.

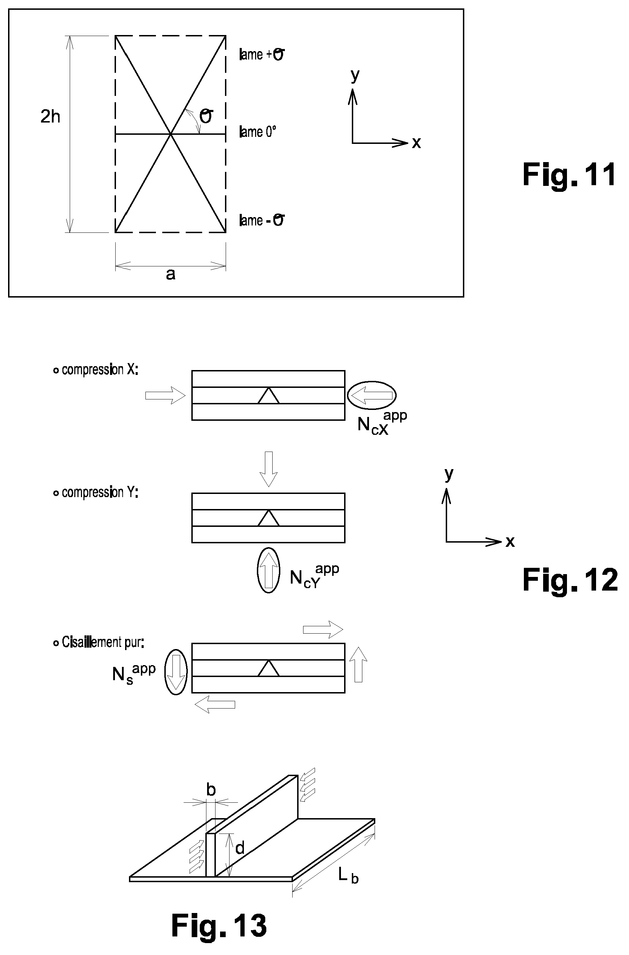

La définition géométrique de la grille de raidisseurs utilisée pour réaliser les calculs est définie figure 11 :

Pour obtenir un panneau raidi par des poches triangulaires, cette forme élémentaire est associée à la peau et est répétée autant de fois que nécessaire. De ce fait, ce procédé ne prend pas en compte le concept de géométrie aux bords.

Pour chaque raidisseur, la section réelle ($A_i^{st}$ avec i: 0°, + θ ou - θ) est donnée par la relation :

$$A_i^{st} = \%A_i \times A^{st} \quad \text{(dans le présent exemple nullement limitatif, seul le cas } \%A_i = 1 \text{ est envisagé).}$$

La section droite des raidisseurs comprend la section du rayon de poche $\left( 2 \cdot R_f^2 \left( 1 - \dfrac{\pi}{4} \right) \right)$.

Quelle que soit leur position sur la grille, les contraintes et déformations sont identiques pour chaque type de raidisseur (0°, +θ, -θ).

Pour prendre en compte la plasticité qui peut survenir dans chaque raidisseur, le module d'Young est spécifique à chaque type de raidisseur (0°, +θ, -θ): $E_{0°}^{st}$, $E_{\theta}^{st}$, $E_{-\theta}^{st}$.

La matrice "matériau" E est définie par :

$$\overline{\overline{E_g}} = \begin{pmatrix} E_{0°}^{st} & 0 & 0 \\ 0 & E_{\theta}^{st} & 0 \\ 0 & 0 & E_{-\theta}^{st} \end{pmatrix}.$$

**Etape 3 - Calcul des charges internes**

**3.1 Plaque équivalente aux raidisseurs**

**3.1.1 Relation entre les déformations globales et les déformations des raidisseurs**

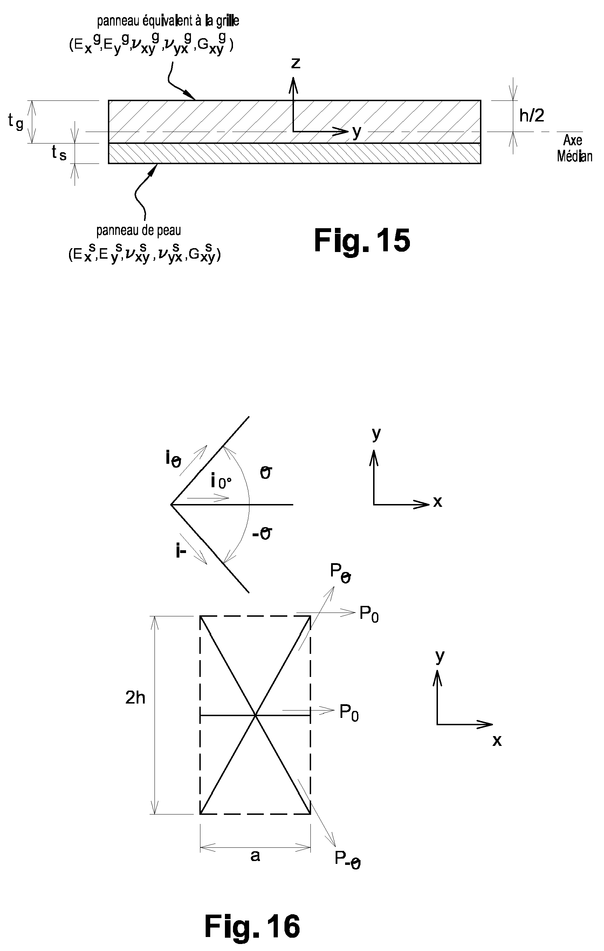

Les notations et conventions géométriques sont illustrées par la figure 16. On recherche la relation entre ($\varepsilon_x$, $\varepsilon_y$, $\varepsilon_{xy}$) et ($\varepsilon_{0°}$, $\varepsilon_{\theta}$, $\varepsilon_{-\theta}$). Les déformations générales sont définies par les formules suivantes :

$$\vec{\varepsilon}_{nn} = \vec{n}.\overline{\overline{\varepsilon}}.\vec{n}$$

Donc on a pour les déformations :

$$\varepsilon_{0°} = \vec{i}_{0°}.\overline{\overline{\varepsilon}}.\vec{i}_{0°} = \begin{pmatrix} 1 & 0 & 0 \end{pmatrix}.\begin{pmatrix} \varepsilon_{xx} & \varepsilon_{xy} & \varepsilon_{xz} \\ \varepsilon_{yx} & \varepsilon_{yy} & \varepsilon_{yz} \\ \varepsilon_{zx} & \varepsilon_{zy} & \varepsilon_{zz} \end{pmatrix}\begin{pmatrix} 1 \\ 0 \\ 0 \end{pmatrix}$$

$$\varepsilon_{\theta} = \vec{i}_{\theta}.\overline{\overline{\varepsilon}}.\vec{i}_{\theta} = \begin{pmatrix} \cos\theta & \sin\theta & 0 \end{pmatrix}.\begin{pmatrix} \varepsilon_{xx} & \varepsilon_{xy} & \varepsilon_{xz} \\ \varepsilon_{yx} & \varepsilon_{yy} & \varepsilon_{yz} \\ \varepsilon_{zx} & \varepsilon_{zy} & \varepsilon_{zz} \end{pmatrix}.\begin{pmatrix} \cos\theta \\ \sin\theta \\ 0 \end{pmatrix}$$

$$\varepsilon_{-\theta} = \vec{i}_{-\theta}.\overline{\overline{\varepsilon}}.\vec{i}_{-\theta} = \begin{pmatrix} \cos\theta & -\sin\theta & 0 \end{pmatrix}.\begin{pmatrix} \varepsilon_{xx} & \varepsilon_{xy} & \varepsilon_{xz} \\ \varepsilon_{yx} & \varepsilon_{yy} & \varepsilon_{yz} \\ \varepsilon_{zx} & \varepsilon_{zy} & \varepsilon_{zz} \end{pmatrix}.\begin{pmatrix} \cos\theta \\ -\sin\theta \\ 0 \end{pmatrix}$$

Et finalement :

$$\begin{pmatrix} \varepsilon_{0°} \\ \varepsilon_{\theta} \\ \varepsilon_{-\theta} \end{pmatrix} = \begin{pmatrix} 1 & 0 & 0 \\ \cos^2\theta & \sin^2\theta & 2\sin\theta\cos\theta \\ 2\cos^2\theta & 2\sin^2\theta & -2\sin\theta\cos\theta \end{pmatrix}.\begin{pmatrix} \varepsilon_x \\ \varepsilon_y \\ \varepsilon_{xy} \end{pmatrix}$$

## Equation 3-1

La matrice ci-dessus est notée **Z**:

$$\overline{\overline{Z}} = \begin{pmatrix} 1 & 0 & 0 \\ \cos^2\theta & \sin^2\theta & 2\sin\theta\cos\theta \\ 2\cos^2\theta & 2\sin^2\theta & -2\sin\theta\cos\theta \end{pmatrix}$$

### 3.1.2 Relation entre contraintes et déformations

Comme on l'a dit, les notations et conventions géométriques sont illustrées par la figure 16. Les charges dans les raidisseurs sont données par l'expression suivante :

$$\vec{P}_i = \varepsilon_i.E^{st}.A^{st}_i.\vec{i}_i \quad , (i = 0°, \ \theta, \ -\theta)$$

## Equation 3-2

Ainsi l'élément de base ci-dessus est soumis à : $\overrightarrow{P_{0°}},\overrightarrow{P_{\theta}},\overrightarrow{P_{-\theta}}$ ($\overrightarrow{P_{0°}}$ compté deux fois puisque la dimension de l'élément de base selon l'axe Y est 2h, donc le raidisseur correspondant à 0° doit aussi être pr is en compte).

Selon l'axe x:

$$P_x^{\,g} = \sum_i \vec{P_i}.\vec{x} = (2\vec{P_{0^\circ}} + \vec{P_\theta} + \vec{P_{-\theta}}).\vec{x} = 2E_{0^\circ}^{\,st} A_{0^\circ}^{\,st} \varepsilon_{0^\circ} + E_\theta^{\,st} A_\theta^{\,st} \varepsilon_\theta \cos\theta + E_{-\theta}^{\,st} A_{-\theta}^{\,st} \varepsilon_{-\theta} \cos\theta$$

Selon l'axe y:

$$P_y^{\,g} = E_\theta^{\,st} A_\theta^{\,st} \varepsilon_\theta \sin\theta + E_{-\theta}^{\,st} A_{-\theta}^{\,st} \varepsilon_{-\theta} \sin\theta$$

Cisaillement dans le plan $(\vec{x}, \vec{y})$ :

$$P_{xy}^{\,g} = E_\theta^{\,st} A_\theta^{\,st} \varepsilon_\theta \sin\theta - E_{-\theta}^{\,st} A_{-\theta}^{\,st} \varepsilon_{-\theta} \sin\theta$$

# Equation 3-3

Pour obtenir les contraintes, la charge est divisée par la surface d'un élément de base. La section de l'élément de base sur une surface normale selon l'axe X est $2ht_g = a\,\tan\theta.t_g$ La section de l'élément de base sur une surface normale selon l'axe Y est de même $at_g$.

En termes de contraintes on a:

$$\sigma_x^{\,g} = \frac{P_x^{\,g}}{2ht_g} = \frac{1}{2ht_g}\left(2E_{0^\circ}^{\,st} A_{0^\circ}^{\,st} \quad E_\theta^{\,st} A_\theta^{\,st} \cos\theta \quad E_{-\theta}^{\,st} A_{-\theta}^{\,st} \cos\theta\right)\begin{pmatrix} \varepsilon_{0^\circ} \\ \varepsilon_\theta \\ \varepsilon_{-\theta} \end{pmatrix}$$

$$\sigma_x^{\,g} = \frac{1}{at_g}\left(\frac{2E_{0^\circ}^{\,st} A_{0^\circ}^{\,st}}{\tan\theta} \quad E_\theta^{\,st} A_\theta^{\,st} \frac{\cos^2\theta}{\sin\theta} \quad E_{-\theta}^{\,st} A_{-\theta}^{\,st} \frac{\cos^2\theta}{\sin\theta}\right).\begin{pmatrix} \varepsilon_{0^\circ} \\ \varepsilon_\theta \\ \varepsilon_{-\theta} \end{pmatrix}$$

Pour $\sigma_y$ et $\tau_{xy}$, on obtient avec la même méthode :

$$\sigma_y^{\,g} = \frac{1}{at_g}\left(0 \quad E_\theta^{\,st} A_\theta^{\,st} \sin\theta \quad E_{-\theta}^{\,st} A_{-\theta}^{\,st} \sin\theta\right)\begin{pmatrix} \varepsilon_{0^\circ} \\ \varepsilon_\theta \\ \varepsilon_{-\theta} \end{pmatrix}$$

$$\tau_{xy}^{\,g} = \frac{1}{at_g}\left(0 \quad E_\theta^{\,st} A_\theta^{\,st} \sin\theta \quad -E_{-\theta}^{\,st} A_{-\theta}^{\,st} \sin\theta\right)\begin{pmatrix} \varepsilon_{0^\circ} \\ \varepsilon_\theta \\ \varepsilon_{-\theta} \end{pmatrix}$$

Les mêmes résultats peuvent être présentés sous forme matricielle :

$$\begin{pmatrix} \sigma_x{}^g \\ \sigma_y{}^g \\ \tau_{xy}{}^g \end{pmatrix} = \frac{1}{at_g} \begin{pmatrix} \dfrac{2E_{0°}{}^{st} A_{0°}{}^{st}}{\tan\theta} & E_\theta{}^{st} A_\theta{}^{st} \dfrac{\cos^2\theta}{\sin\theta} & E_{-\theta}{}^{st} A_{-\theta}{}^{st} \dfrac{\cos^2\theta}{\sin\theta} \\ 0 & E_\theta{}^{st} A_\theta{}^{st} \sin\theta & E_{-\theta}{}^{st} A_\theta{}^{st} \sin\theta \\ 0 & E_\theta{}^{st} A_\theta{}^{st} \sin\theta & -E_{-\theta}{}^{st} A_\theta{}^{st} \sin\theta \end{pmatrix} \cdot \begin{pmatrix} \varepsilon_{0°} \\ \varepsilon_\theta \\ \varepsilon_{-\theta} \end{pmatrix}$$

## Equation 3-4

La matrice ci-dessus est notée **T** :

$$\overline{\overline{T}} = \frac{1}{at_g} \begin{pmatrix} \dfrac{2E_{0°}{}^{st} A_{0°}{}^{st}}{\tan\theta} & E_\theta{}^{st} A_\theta{}^{st} \dfrac{\cos^2\theta}{\sin\theta} & E_{-\theta}{}^{st} A_{-\theta}{}^{st} \dfrac{\cos^2\theta}{\sin\theta} \\ 0 & E_\theta{}^{st} A_\theta{}^{st} \sin\theta & E_{-\theta}{}^{st} A_\theta{}^{st} \sin\theta \\ 0 & E_\theta{}^{st} A_\theta{}^{st} \sin\theta & -E_{-\theta}{}^{st} A_\theta{}^{st} \sin\theta \end{pmatrix}$$

En utilisant alors l'Equation 3-1 et la notation de la matrice **Z** :

$$\begin{pmatrix} \sigma_x{}^g \\ \sigma_y{}^g \\ \tau_{xy}{}^g \end{pmatrix} = \overline{\overline{T}} . \overline{\overline{Z}} . \begin{pmatrix} \varepsilon_x \\ \varepsilon_y \\ \varepsilon_{xy} \end{pmatrix}$$

## Equation 3-5

La matrice qui précède est notée **W** : $\overline{\overline{W}} = \overline{\overline{T}}.\overline{\overline{Z}}$

Cette relation (Equation 3-5) signifie que le comportement du panneau équivalent aux raidisseurs est similaire à un matériau anisotrope (la matrice **W** peut être complète : toutes ses cellules ont des valeurs non nulles).

### 3.2 Panneaux raidis

On utilise l'hypothèse de Kirchhoff : des sections planes restent planes après déformation. Le réseau de raidisseurs est modélisé par un panneau équivalent avec une matrice de comportement **W** (voir l'Equation 3-5). Cette disposition de modélisation du panneau raidi par des poches triangulaires, par deux plaques orthotropes est illustrée par la figure 15.

Pour le calcul de $v_{yx}$, on a :

$$\frac{v_{xy}{}^s}{E_x{}^s} = \frac{v_{yx}{}^s}{E_y{}^s}$$

### 3.2.1 Contraintes et charges des raidisseurs

### Flux dans le panneau équivalent aux raidisseurs

L'expression générale des flux est :

$$N_{\alpha\beta} = \int_h \sigma_{\alpha\beta} dz$$

## Equation 3-6

Le flux selon l'axe X s'exprime comme suit :

$$N_{xx} = \int_h \sigma_{xx} dz = \int_{-\frac{h}{2}}^{-\frac{h}{2}+t_s} \sigma_{xx}{}^s dz + \int_{-\frac{h}{2}+t_s}^{\frac{h}{2}} \sigma_{xx}{}^g dz$$

$$N_{xx} = \frac{E_x{}^s t_s}{1 - v_{xy}{}^s v_{yx}{}^s}.\varepsilon_{xx} + \frac{v_{xy}{}^s E_y{}^s t_s}{1 - v_{xy}{}^s v_{yx}{}^s}.\varepsilon_{yy} + \sigma_{xx}{}^g .t_g$$

en utilisant l'Equation 3-5:

$$N_x = \left[ \frac{E_x{}^s t_s}{1 - v_{xy}{}^s v_{yx}{}^s} + t_g.\overline{\overline{W}}_{1,1} \right].\varepsilon_x + \left[ \frac{v_{xy}{}^s E_y{}^s t_s}{1 - v_{xy}{}^s v_{yx}{}^s} + t_g.\overline{\overline{W}}_{1,2} \right].\varepsilon_y + t_g.\overline{\overline{W}}_{1,3}.\varepsilon_{xy}$$

Et, en utilisant la même méthode pour les flux $N_y$ et $N_{xy}$:

$$N_y = \left[ \frac{v_{yx}{}^s E_x{}^s t_s}{1 - v_{xy}{}^s v_{yx}{}^s} + t_g.\overline{\overline{W}}_{2,1} \right].\varepsilon_x + \left[ \frac{E_y{}^s t_s}{1 - v_{xy}{}^s v_{yx}{}^s} + t_g.\overline{\overline{W}}_{2,2} \right].\varepsilon_y + t_g.\overline{\overline{W}}_{2,3}.\varepsilon_{xy}$$

$$N_{xy} = t_g.\overline{\overline{W}}_{3,2}.\varepsilon_x + t_g.\overline{\overline{W}}_{3,3}.\varepsilon_y + \left( 2G_{xy}t_s + t_g.\overline{\overline{W}}_{3,1} \right)\varepsilon_{xy}$$

## Equation 3-7

Ces expressions montrent clairement la répartition du flux entre la peau et le panneau équivalent aux raidisseurs. Dans la peau, la relation entre les flux et déformations est :

$$\begin{pmatrix} N_x{}^s \\ N_y{}^s \\ N_{xy}{}^s \end{pmatrix} = \begin{pmatrix} N_x \\ N_y \\ N_{xy} \end{pmatrix} - \begin{pmatrix} N_x{}^g \\ N_y{}^g \\ N_{xy}{}^g \end{pmatrix} = \begin{pmatrix} \dfrac{E_x{}^s t_s}{1 - v_{xy}{}^s v_{yx}{}^s} & \dfrac{v_{xy}{}^s E_y{}^s t_s}{1 - v_{xy}{}^s v_{yx}{}^s} & 0 \\ \dfrac{v_{yx}{}^s E_x{}^s t_s}{1 - v_{xy}{}^s v_{yx}{}^s} & \dfrac{E_y{}^s t_s}{1 - v_{xy}{}^s v_{yx}{}^s} & 0 \\ 0 & 0 & 2G_{xy}{}^s t_s \end{pmatrix} . \begin{pmatrix} \varepsilon_x \\ \varepsilon_y \\ \varepsilon_{xy} \end{pmatrix}$$

## Equation 3-8

On note **X** la matrice précédente :

$$\overline{\overline{X}} = \begin{pmatrix} \dfrac{E_x^{\;s} t_s}{1 - v_{xy}^{\;s} v_{yx}^{\;s}} & \dfrac{v_{xy}^{\;s} E_y^{\;s} t_s}{1 - v_{xy}^{\;s} v_{yx}^{\;s}} & 0 \\[2ex] \dfrac{v_{yx}^{\;s} E_x^{\;s} t_s}{1 - v_{xy}^{\;s} v_{yx}^{\;s}} & \dfrac{E_y^{\;s} t_s}{1 - v_{xy}^{\;s} v_{yx}^{\;s}} & 0 \\[2ex] 0 & 0 & 2 G_{xy}^{\;s} t_s \end{pmatrix}$$

Alors :

$$\begin{pmatrix} N_x \\ N_y \\ N_{xy} \end{pmatrix} = \begin{pmatrix} N_x^{\;g} \\ N_y^{\;g} \\ N_{xy}^{\;g} \end{pmatrix} + \frac{1}{t_g} . \overline{\overline{X}} . \overline{\overline{W}}^{-1} . \begin{pmatrix} N_x^{\;g} \\ N_y^{\;g} \\ N_{xy}^{\;g} \end{pmatrix}$$

**Equation 3-9**

En inversant cette relation, les flux dans la grille sont exprimés en fonction des flux appliqués globaux :

$$\begin{pmatrix} N_x^{\;g} \\ N_y^{\;g} \\ N_{xy}^{\;g} \end{pmatrix} = V . \begin{pmatrix} N_x \\ N_y \\ N_{xy} \end{pmatrix}$$

**Equation 3-10**

Avec:

$$\overline{\overline{V}} = \left( \overline{\overline{I_d}} + \frac{1}{t_g} . \overline{\overline{X}} . \overline{\overline{W}}^{-1} \right)^{-1}$$

($\overline{\overline{I_d}}$ est la matrice identité)

**Contraintes et charges dans les raidisseurs**

Les flux dans le panneau équivalent aux raidisseurs peuvent être exprimés par :

$$\begin{pmatrix} N_x^{\;g} \\ N_y^{\;g} \\ N_{xy}^{\;g} \end{pmatrix} = t_g . \overline{\overline{T}} . \begin{pmatrix} \varepsilon_{0^\circ} \\ \varepsilon_{\theta} \\ \varepsilon_{-\theta} \end{pmatrix}$$

**Equation 3-11**

$$\begin{pmatrix} N_x^{\ g} \\ N_y^{\ g} \\ N_{xy}^{\ g} \end{pmatrix} = t_g . \overline{\overline{T}} . \overline{\overline{E_g}}^{-1} . \begin{pmatrix} \sigma_{0°} \\ \sigma_\theta \\ \sigma_{-\theta} \end{pmatrix}$$

## Equation 3-12

En utilisant la notation suivante : $\overline{\overline{U}} = t_g . \overline{\overline{T}} . \overline{\overline{E_g^{-1}}}$ On a :

$$\begin{pmatrix} \sigma_{0°} \\ \sigma_\theta \\ \sigma_{-\theta} \end{pmatrix} = U^{-1} . \begin{pmatrix} N_x^{\ g} \\ N_y^{\ g} \\ N_{xy}^{\ g} \end{pmatrix}$$

## Equation 3-13

Finalement, les charges et contraintes dans les raidisseurs s'expriment en fonction des flux de charges externes :

$$\begin{pmatrix} \sigma_{0°} \\ \sigma_\theta \\ \sigma_{-\theta} \end{pmatrix} = U^{-1} . V . \begin{pmatrix} N_x \\ N_y \\ N_{xy} \end{pmatrix} \quad \text{et} \quad \begin{pmatrix} F_{0°} \\ F_\theta \\ F_{-\theta} \end{pmatrix} = \begin{pmatrix} A_{0°}^{\ st} \\ A_\theta^{\ st} \\ A_{-\theta}^{\ st} \end{pmatrix} . \begin{pmatrix} \sigma_{0°} \\ \sigma_\theta \\ \sigma_{-\theta} \end{pmatrix}$$

## Equation 3-14

### 3.2.2 Flux et contraintes dans la peau

Comme montré par l'Equation 3-8, les flux dans la peau s'expriment comme ci-dessous :

$$\begin{pmatrix} N_x^{\ s} \\ N_y^{\ s} \\ N_{xy}^{\ s} \end{pmatrix} = \begin{pmatrix} N_x \\ N_y \\ N_{xy} \end{pmatrix} - \begin{pmatrix} N_x^{\ g} \\ N_y^{\ g} \\ N_{xy}^{\ g} \end{pmatrix}$$

## Equation 3-15

ainsi, les contraintes dans la peau sont exprimées par :

$$\begin{pmatrix} \sigma_x^{\ s} \\ \sigma_y^{\ s} \\ \tau_{xy}^{\ s} \end{pmatrix} = \frac{1}{t_s} . \begin{pmatrix} N_x^{\ s} \\ N_y^{\ s} \\ N_{xy}^{\ s} \end{pmatrix}$$

## Equation 3-16

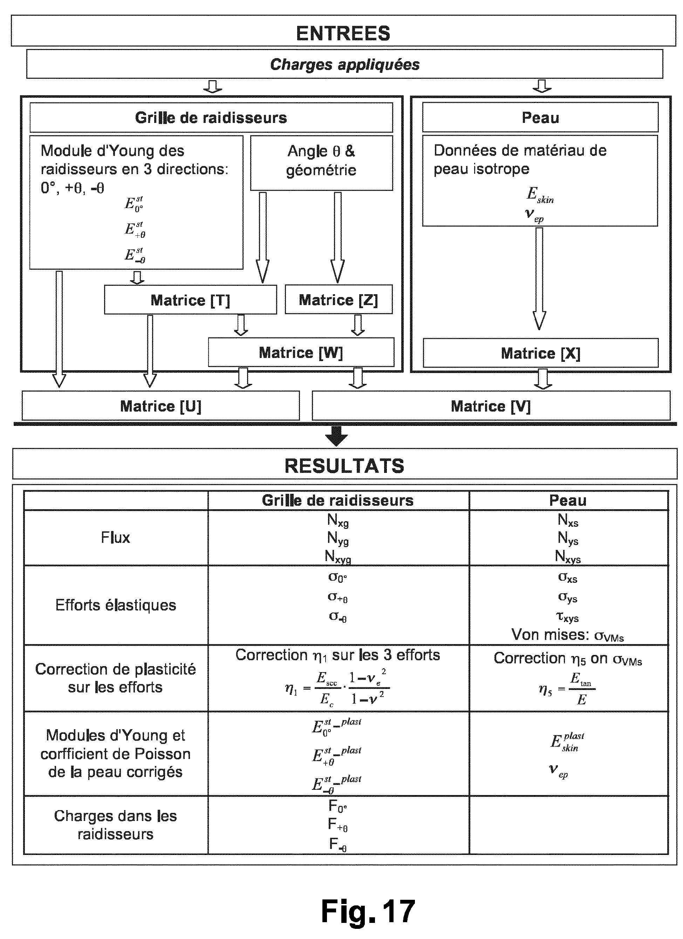

3.3 Le procédé de **calcul de charges appliquées corrigées de la plasticité** est présenté ici avec les références aux matrices introduites dans la description (figure 17).

On note que la théorie utilisée pour calculer la plasticité suppose l'isotropie du matériau formant la peau. La solution pour les charges appliquées corrigées pour la plasticité est fournie par une méthode itérative.

Un procédé de convergence doit être réalisé jusqu'à ce que les cinq paramètres du matériau ($E_{0°}^{st}$, $E_{+\theta}^{st}$, $E_{-\theta}^{st}$, $E_{peau}$, $v_{ep}$) entrés au début du processus itératif soient égaux aux mêmes paramètres calculés en sortie (après calcul de contrainte plastique). Dans la figure 17, déjà citée, les paramètres de convergence sont indiqués par un fond grisé.

Plus précisément, dans ce processus itératif, les entrées initiales sont les charges appliquées dans la grille des raidisseurs, et dans la peau.

Pour la grille des raidisseurs, les données de la i$^{ème}$ itération de Module d'Young des raidisseurs $E_{0°}^{st}$, $E_{+\theta}^{st}$, $E_{-\theta}^{st}$ en 3 directions : 0°, +θ,-θ, permettent, en association avec la valeur de l'angle θ et de la géométrie, de calculer la matrice [T] (équation 3-4). Les valeurs d'angle θ et de géométrie fournissent la matrice [Z] (équation 3-1). Les matrices [T] et [Z] donnent la matrice [W] (équation 3-5).

Pour la peau, les données de matériau de peau isotrope $E_{peau}$, $v_{ep}$) permettent de calculer la matrice [X] (équation 3-8).

Les matrices [W] et [X] permettent de calculer les matrices [U] (équation 3-13) et [V] (équation 3-10).

Les résultats tirés de ces matrices comprennent : les flux, les efforts élastiques, les corrections de plasticité sur les efforts, les valeurs de la i+1$^{ème}$ itération des Modules d'Young des raidisseurs et de la peau corrigés, et du coefficient de Poisson de la peau corrigé, et les charges dans les raidisseurs.

On comprend que le calcul est itéré jusqu'à ce que les modules d'Young et coefficients de Poisson varient au cours d'une itération d'une valeur inférieure à un seuil prédéterminé.

Impact de la correction de plasticité sur le calcul de flambage général :

Naturellement, la correction de plasticité altère la matrice de loi de comportement calculée dans le module d'instabilité générale à travers les 5 paramètres de matériau (voir la partie sur l'instabilité générale).

$$\begin{pmatrix} N_{xx} \\ N_{yy} \\ N_{xy} \\ -M_{xx} \\ M_{yy} \\ -M_{xy} \end{pmatrix} = \begin{pmatrix} \overline{\overline{\mathbf{A}}} & | & \overline{\overline{\mathbf{B}}} \\ - & - & | & - & - & - \\ \overline{\overline{\mathbf{B}}} & | & \overline{\overline{\mathbf{C}}} \end{pmatrix} \cdot \begin{pmatrix} \varepsilon_{xx}^0 \\ \varepsilon_{yy}^0 \\ \varepsilon_{xy}^0 \\ \kappa_{xx} \\ \kappa_{yy} \\ \kappa_{xy} \end{pmatrix} = \begin{pmatrix} A_{11} & A_{12} & A_{13} & B_{11} & B_{12} & B_{13} \\ A_{12} & A_{22} & A_{23} & B_{12} & B_{22} & B_{23} \\ A_{13} & A_{23} & A_{11} & B_{13} & B_{23} & B_{33} \\ B_{11} & B_{12} & B_{13} & C_{11} & C_{12} & C_{13} \\ B_{12} & B_{11} & B_{23} & C_{12} & C_{22} & C_{23} \\ B_{13} & B_{23} & B_{33} & C_{13} & C_{23} & C_{33} \end{pmatrix} \cdot \begin{pmatrix} \varepsilon_{xx}^0 \\ \varepsilon_{yy}^0 \\ \varepsilon_{xy}^0 \\ \kappa_{xx} \\ \kappa_{yy} \\ \kappa_{xy} \end{pmatrix}$$

## Equation 3-17

De ce fait, la correction de plasticité altère également les coefficients $\Omega_i$ (i=1..3) utilisés pour le calcul du flambage général. La correction de plasticité dans l'analyse de flambage général est fournie par ces coefficients modifiés $\Omega_i$.

**3.4 Exemple: distribution de charges sous bi-compression et cisaillement**

Dans l'étape de calcul de contraintes appliquées, le rayon de filet de la poche est pris en compte pour le calcul de la section du raidisseur. Par ailleurs, il n'y a pas de post-flambage, on peut donc écrire :

$$\%A_{0°}^{st} = \%A_{+\theta}^{st} = \%A_{-\theta}^{st} = 100\%$$

$$t_{s\_eff} = t_s$$

Dans le présent exemple décrit ici à titre nullement limitatif, la géométrie du panneau raidi par des poches triangulaires est définie par :

$L_x$ = 1400.45 mm    a = 198 mm    rayon de noeud : $R_n$ = 9 mm
$L_y$ = 685.8 mm    t = 3.64 mm    rayon de poche : $R_f$ = 4 mm
θ = 58°    b = 2.5 mm    d = 37.36mm

On considère un matériau isotrope. La loi élasto-plastique utilisée est celle de Ramberg & Osgood.

| E | 78000 |
|---|---|
| Nu | 0.3 |
| Ftu | 490 |
| Fty | 460 |
| e% | 20% |
| n | 40 |

Les charges externes appliquées (à charge ultime) sont :

$$N_x = -524.65 N/mm$$

$$N_y = -253.87 N/mm$$

$$N_{xy} = 327.44 N/mm$$

Le procédé de calcul de charges internes et de charges appliquées incluant la correction de plasticité s'écrit sous forme matricielle :

W = T*Z

| sigxg | | | 1518 | 504 | 0 | | | epsx |
|---|---|---|---|---|---|---|---|---|
| sigyg | = | | 504 | 1290 | 0 | * | | epsy |
| tauxyg | | | 0 | 0 | 504 | | | gamxy |

X

| Nx-Nxg | | | 312000 | 93600 | 0 | | | epsx |
|---|---|---|---|---|---|---|---|---|
| Ny-Nyg | = | | 93600 | 312000 | 0 | * | | epsy |
| Nxy-Nxyg | | | 0 | 0 | 109200 | | | gamxy |

V

| Nxg | | | 0.152 | 0.005 | 0.000 | | | Nx |
|---|---|---|---|---|---|---|---|---|
| Nyg | = | | 0.011 | 0.130 | 0.000 | * | | Ny |
| Nxyg | | | 0.000 | 0.000 | 0.147 | | | Nxy |

U⁻¹

| sig 0° | | | 1.580 | -0.617 | 0.000 | | | Nxg |
|---|---|---|---|---|---|---|---|---|
| sig +theta | = | | 0.000 | 1.164 | 1.863 | * | | Nyg |
| sig -theta | | | 0.000 | 1.164 | -1.863 | | | Nxyg |

On obtient alors comme résultats les flux, contraintes et charges dans les raidisseurs :

$N_{xg}$ = -81.1 N/mm    $\sigma_{0°}$ = -101.14 MPa    $F_{0°}$ = -10441 N
$N_{yg}$ = -39 N/mm    $\sigma_{+\theta}$ = 44.25 MPa    $F_{+\theta}$ = 4437 N
$N_{xyg}$ = 48.1 N/mm    $\sigma_{-\theta}$ = -135.07 MPa    $F_{-\theta}$ = -13537 N

Ainsi que les flux et contraintes dans la peau :

$$N_{xs} = -443.5 N/mm \qquad \sigma_{xs} = -121.85 MPa$$
$$N_{ys} = -214.87 N/mm \qquad \sigma_{ys} = -59.03 MPa$$
$$N_{xys} = 279.3 N/mm \qquad \tau_{xys} = 76.74 MPa$$

Dans cet exemple, les contraintes appliquées demeurent dans le domaine élastique.

La distribution de flux entre la peau et la grille de raidisseurs est résumée par le tableau suivant :

| Flux (N / mm) | Flux externes | Distribution de charges - Flux | | Distribution de charges - Pourcentages | |
|---|---|---|---|---|---|
| | | Grille | Peau | Grille | Peau |
| Nx | -524.65 | -81.13 | -443.52 | 15.46% | 84.54% |
| Ny | -253.87 | -39.00 | -214.87 | 15.36% | 84.64% |
| Nxy | +327.44 | +48.12 | +279.32 | 14.7% | 85.3% |

**Etape 4 - Module d'analyse de résistance :**

Cette phase a pour but le calcul de facteurs de réserve (RF) par comparaison des charges appliquées calculées dans les composants du panneau raidi par des poches triangulaires, et les contraintes maximums admissibles du matériau.

Les contraintes admissibles dans le matériau à charge ultime sont déterminés par : $F_{tu}$ (Résistance de tension ultime du matériau) comparé aux contraintes appliquées dans les âmes des raidisseurs, $F_{tu}$ comparé aux contraintes principales appliquées dans la peau, $F_{su}$ (Résistance de cisaillement ultime du matériau) comparé à la contrainte de cisaillement maximal dans la peau.

L'analyse de résistance consiste à calculer les facteurs de réserve du matériau à la charge limite et à la charge ultime. Les charges appliquées proviennent des charges dans le plan (compression, cisaillement) ou hors du plan (pression).

Les données d'entrée pour ce calcul sont :

- Valeurs admissible pour le matériau : $F_{ty}$, $F_{cy}$, $F_{sy}$, $F_{tu}$, $F_{su}$
- Contraintes appliquées à la structure :

  ○ Contraintes sur la peau ($\sigma_{xs}$, $\sigma_{ys}$ et $\tau_{xys}$)
  ○ Contraintes normales dans les raidisseurs

Note: les contraintes appliquées sont corrigées pour la plasticité dans le procédé de calcul de contrainte appliquée, comme on l'a dit plus haut.

Les données de sortie sont les facteurs de réserve.

L'analyse de résistance dans le plan du panneau se base sur les hypothèses suivantes. Les contraintes dans la peau ne sont pas une fonction de l'épaisseur de la peau et de la position dans le plan. Les contraintes dans un raidisseur ne sont pas fonction de la position sur la section du raidisseur, mais seulement de l'angle du raidisseur.

Ces hypothèses ne sont plus valables lorsque le post-flambage et le comportement en dehors du plan sont également pris en compte. Dans ces cas, des fonctions max/min, de type connu en soi, doivent être mise en oeuvre pour tenir compte de ces phénomènes.

**Calcul des contraintes principales:**

Pour calculer le facteur de réserve de la peau, les contraintes principales ($\sigma_{max}$, $\sigma_{min}$ et $\sigma_{max}$) sont utilisées :

$$\sigma_{max\_s} = \frac{\sigma_{xs} + \sigma_{ys}}{2} + \sqrt{\frac{(\sigma_{xs} - \sigma_{ys})^2}{2} + \tau_{xys}^2}$$

$$\sigma_{min\_s} = \frac{\sigma_{xs} + \sigma_{ys}}{2} - \sqrt{\frac{(\sigma_{xs} - \sigma_{ys})^2}{2} + \tau_{xys}^2}$$

$$\tau_{max} = \frac{\sigma_{max\_s} - \sigma_{min\_s}}{2}$$

## Equation 4-1

La valeur $\sigma_{max}$ utilisée dans le calcul du facteur de réserve est définie comme le maximum absolu entre $\sigma_{max\_s}$ et $\sigma_{min\_s}$ calculés dans l'Equation 4-1.

Facteur de réserve à charge limite (LL) :

Facteur de réserve sur les âmes des raidisseurs :

- $$RF_{in\_plane\_LL}^{blade\_0} = \frac{F_y}{\sigma_{blade\_0\_LL}}$$

- $$RF_{in\_plane\_LL}^{blade\_+\theta} = \frac{F_y}{\sigma_{blade\_+\theta\_LL}}$$

- $$RF_{in\_plane\_LL}^{blade\_-\theta} = \frac{F_y}{\sigma_{blade\_-\theta\_LL}}$$

Facteur de réserve sur la peau :

Cisaillement maximal : $RF_{in\_plane\_LL}^{skin\_shear} = \dfrac{F_{sy}}{\tau_{max\_LL}}$

Dans cette formule, si $F_{sy}$ n'est pas connu, $F_{su} / \sqrt{3}$ peut être utilisé

Contrainte principale : $RF_{in\_plane\_LL}^{skin} = \dfrac{F_y}{\sigma_{max\_LL}}$

- Un facteur de réserve enveloppe est calculé à charge limite :

$$RF_{material\_LL} = \min\left\{ RF_{in\_plane\_LL}^{blade\_0} ; RF_{in\_plane\_LL}^{blade\_+\theta} ; RF_{in\_plane\_LL}^{blade\_-\theta} ; RF_{in\_plane\_LL}^{skin\_shear} ; RF_{in\_plane\_LL}^{skin} \right\}$$

## Equation 4-2

Facteur de réserve à charge ultime UL :

- Facteur de réserve sur les âmes des raidisseurs:

$$RF_{in\_plane\_UL}^{blade\_0} = \frac{F_u}{\sigma_{blade\_0\_UL}} \quad (*)$$

$$RF_{in\_plane\_UL}^{blade\_+\theta} = \frac{F_u}{\sigma_{blade\_+\theta\_UL}} \quad (*)$$

$$RF_{in\_plane\_UL}^{blade\_-\theta} = \frac{F_u}{\sigma_{blade\_-\theta\_UL}}$$

Note: si $F_{cu}$ n'est pas connu, $F_{cy}$ ou $F_{tu}$ peut être utilisé

- Facteur de réserve sur la peau:

Cisaillement maximal: $RF_{in\_plane\_UL}^{skin\_shear} = \dfrac{F_{su}}{\tau_{max\_UL}}$

Contrainte principale : $RF_{in\_plane\_UL}^{skin} = \dfrac{F_u}{\sigma_{max\_UL}}$

- Un facteur de réserve enveloppe est calculé à charge ultime :

$$RF_{material\_UL} = \min\left\{RF_{in\_plane\_UL}^{blade\_0}; RF_{in\_plane\_UL}^{blade\_+\theta}; RF_{in\_plane\_UL}^{blade\_-\theta}; RF_{in\_plane\_UL}^{skin\_shear}; RF_{in\_plane\_UL}^{skin}\right\}$$

L'analyse de résistance hors du plan du panneau sort du cadre de la présente invention.

Dans un exemple de mise en oeuvre de cette partie du procédé, d'analyse de résistance dans le plan, la même géométrie et le même cas de charges que dans les parties précédentes est étudié. Dans un premier temps, le ratio de facteur de charges est supposé égal à 1.

Facteur de réserve des âmes des raidisseurs :

$$RF_{in\_plane\_UL}^{blade\_0} = 4.71$$

$$RF_{in\_plane\_UL}^{blade\_+\theta} = 11.14$$

$$RF_{in\_plane\_UL}^{blade\_-\theta} = 3.63$$

Facteur de réserve de la peau :

Calcul des contraintes principales:

$$\sigma_{max\_s} = -7.52 MPa$$

$$\sigma_{min\_s} = -173.35 MPa$$

$$\tau_{\max} = 82.91 MPa$$

$$\Rightarrow \sigma_{\max\_skin\_UL} = 173.35 MPa$$

Cisaillement maximal : $RF_{in\_plane\_UL}^{skin\_shear} = 3.41$

Contrainte principale : $RF_{in\_plane\_UL}^{skin} = 2.82$

Facteur de réserve enveloppe RF à charge ultime (UL)

$$RF_{material\_UL} = 2.82$$

Dans le cas de calcul plastique, un calcul itératif est réalisé jusqu'à ce que les charges appliquées atteignent la charge de résistance d'effondrement (de manière à effectuer sur elles une correction de plasticité). A chaque boucle d'itération, les mêmes calculs que décrits précédemment sont réalisés.

### Etape 5 - Calcul de contraintes locales admissibles

Deux types d'instabilité affaiblissent la raideur globale de la structure raidie par des poches triangulaires, mais ne causent pas l'effondrement global de la structure complète

Instabilité du panneau : flambage des poches triangulaires
Instabilité des raidisseurs : flambage des âmes des raidisseurs

Les parties flambées peuvent supporter seulement une partie de la charge qu'elles auraient supportée avant leur flambage. De ce fait, les charges appliquées sont redistribuées dans la structure.
On note que dans la présente invention, les calculs post-flambage ne sont pas traités. De ce fait, les deux types de flambage cités ci-dessus sont considérés comme des modes d'effondrement.

### 5A - Calcul de flambage local du panneau:

Dans les panneaux raidis par des poches triangulaires, les **poches** sont des plaques triangulaires soumises à des chargements combinés dans le plan. De manière à calculer des flux de flambage admissible et des facteurs de réserve sous un chargement pur du panneau raidi complet, une méthode basée sur un modèle par éléments finis (FEM) est utilisée.
Cette partie fournit un calcul de flux de flambage de poche admissible pour des plaques triangulaires isocèles: la base du triangle peut varier entre toutes valeurs, et, dans le présent exemple non limitatif, entre 45° et 70°. Le calcul de flux est réalisé avec deux types de conditions aux limites : en appui simple ("simply supported,") et encastrées ("clamped")
Les contraintes appliquées à prendre en compte pour le calcul de facteur de réserve sont les contraintes agissant dans la peau uniquement, et déterminés dans la partie, décrite plus haut, de calcul de contraintes appliquées.
Les données d'entrée de cette partie sont :

- données géométriques (base du triangle, angle isocèle, épaisseur de la peau)
- données du matériau (linéaire (E, v) et non-linéaire ($F_{cy}$, $F_{tu}$, e%, $n_c$))

  ○ matériau isotrope uniquement
  ○ les valeurs de flux de flambage plastique admissible sont pertinentes jusqu'à $F_{cy}$ seulement

- Conditions aux limites: en appui simple ou encastrées
- Charges appliquées à la peau

Il est à noter que tous les flux externes utilisés dans cette partie sont des flux de peau et ne correspondent pas au chargement complet du panneau raidi. Par ailleurs, la hauteur du triangle (h) utilisée comme longueur de référence pour le calcul de flambage est réduite de la demi-épaisseur des âmes des raidisseur.

Dans cette partie, la formule utilisée pour la hauteur du triangle est : *h=h_red*

$$h\_red = \frac{a\_red}{2} \cdot \tan\theta$$

$$a\_red = a - b \cdot \left[\frac{1}{\tan\theta} + \frac{1}{\sin\theta}\right]$$

Les données de sortie sont les suivantes :

- Flambage de poche admissible.
- Facteur de réserve

Cette partie a pour but de calculer des flux admissibles pour des plaques triangulaires isocèles.

Elle comporte deux parties : 1/ Calcul de valeurs admissibles pour des plaques triangulaires en appui simple (partie 5A.5), 2/ Calcul de valeurs admissibles pour des plaques triangulaires encastrées (partie 5A.6).

Les deux parties suivent la même démarche : d'abord un calcul de valeurs admissibles pour des plaques triangulaires soumises à des cas de chargement pur (compression selon X, compression selon Y et cisaillement), puis un calcul des courbes d'interaction entre les trois cas de chargement pur

### 5A.1 Principe de calcul

Les cas de chargement pur envisagés sont présentés dans la figure 12.

Il existe dans la littérature plusieurs méthodes de formulation analytique du flambage local de triangles. La comparaison entre ces méthodes montre de grandes différences entre les contraintes de flambage prédites. Plus encore, certains des paramètres utilisés dans ces méthodes sont dérivés de calculs par éléments finis, les tests sont souvent empiriques et certaines méthodes ne fournissent aucune donnée pour des angles différents de 60°

Le développement d'une théorie complète de ce problème étant long, le procédé tel que décrit ici à titre nullement limitatif met en oeuvre une méthode basée entièrement sur un Modèle Eléments Finis (FEM):

- Création d'un modèle paramétrique FEM d'une plaque triangulaire (paramètres: angle de base, épaisseur, hauteur du triangle, conditions aux limites),
- Exécution de nombreuses combinaisons différentes pour obtenir des résultats de flambage linéaires,
- Obtention de paramètres qui puissent être utilisés dans une formulation analytique (coefficients K).

Les effets de plasticité induits doivent également être pris en compte dans le calcul des valeurs admissibles. Les charges appliquées sont soit des charges simples, soit des combinaisons de ces charges simples.

### 5A.2 Cas de chargement pur

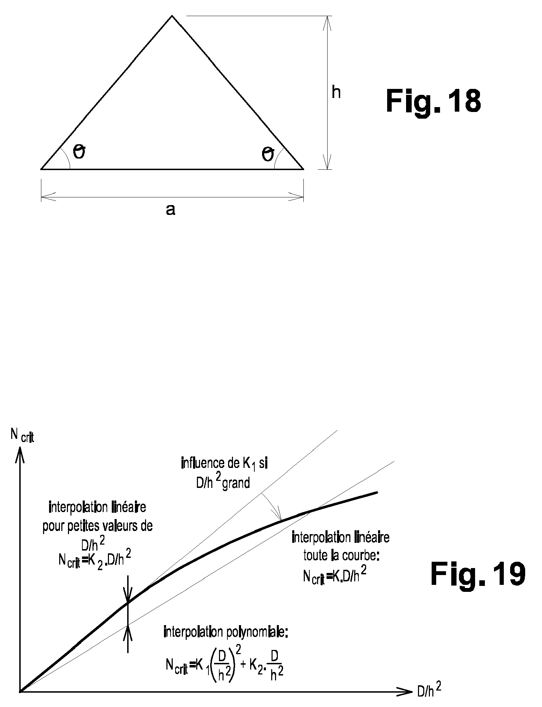

Des courbes d'interaction sont définies comme suit. Six modèles éléments finis de plaques triangulaires ont été créés avec des angles compris entre 45° et 70°, dans le présent exemple nullement limitatif en ce qui concerne les angles du triangle. Dans cette partie, **l'angle isocèle** (θ) est défini comme l'angle de base du triangle isocèle (voir figure 18). Pour chaque angle isocèle et pour chaque cas de chargement pur, l'étude est organisée en trois points :

### 1/ Calcul par Modèle Eléments Finis (FEM)

Des calculs linéaires de flambage local des triangles par modèle éléments finis (FEM) de type connu, ont été réalisés pour déterminer le flux admissible de plissement (sans correction plastique) pour diverses épaisseurs de plaque et donc diverses rigidités. On note que le premier mode observé présente toujours un seul flambage (une seule bosse).

**2/ tracé de la courbe de flux de flambage admissible en fonction de** $\dfrac{D}{h^2}$

De façon générale, dans la littérature, le flux de flambage admissible est exprimé comme suit :

$$N_{crit} = K . \frac{D}{h^2}$$

$K$ est une constante,

$D$ la raideur de plaque : $D = \dfrac{E.t^3}{12\left(1 - v^2\right)}$,

$h$ est la hauteur du triangle: $h = \dfrac{a}{2} . \tan \theta$.

Mais cette étude démontre que, dans le cas de plaques triangulaires, et pour de petites valeurs du rapport $\dfrac{D}{h^2}$, il n'est pas pertinent d'exprimer le flux de flambage admissible avec une équation au premier degré en $\dfrac{D}{h^2}$. Des résultats meilleurs sont obtenus avec une équation au second degré de la forme suivante :

$$N_{crit} = K_1 \left( \frac{D}{h^2} \right)^2 + K_2 . \frac{D}{h^2} \text{ (valeur élastique)}$$

## Equation 5-1

Les constantes $K_1$ et $K_2$ dépendent de l'angle et du cas de charge considéré. Donc, pour chaque cas et chaque angle, une valeur des constantes $K_1$ et $K_2$ est obtenue.

### 3/ tracé de l'évolution de $K_1$ et $K_2$ en fonction de l'angle de base du triangle isocèle

$K_1$ et $K_2$ sont tracés en fonction de l'angle et une interpolation est réalisée pour déterminer une équation polynomiale qui permet de calculer ces constantes quel que soit l'angle compris entre 45° et 70°. La figure 19 illustre une interpolation linéaire ou quadratique pour les coefficients K. Il est clair que cette fonction permet également d'extrapoler à des valeurs en dehors mais proches du domaine allant de 45 à 70°. Ainsi, en connaissant l'angle isocèle et les conditions aux limites, il est possible de calculer directement le flux de flambage admissible de la plaque triangulaire étudiée.

### 5A.3 Cas de chargement combiné

On utilise dans ce cas l'hypothèse suivante : si certains composants de la charge combinée sont en tension, alors ces composants sont ramenés à zéro (ne sont pas pris en compte pour le calcul). Il est en effet conservatif de considérer que des composants en tension n'ont pas d'effet vis à vis du flux de flambage étudié, et n'améliorent pas la contrainte de flambage de la plaque. Par exemple, si $N_x^{app}=+200N/mm$ (qui met en évidence une tension) et $N_s^{app}=300N/mm$, la charge combinée admissible est réduite à la charge admissible de cisaillement pur.

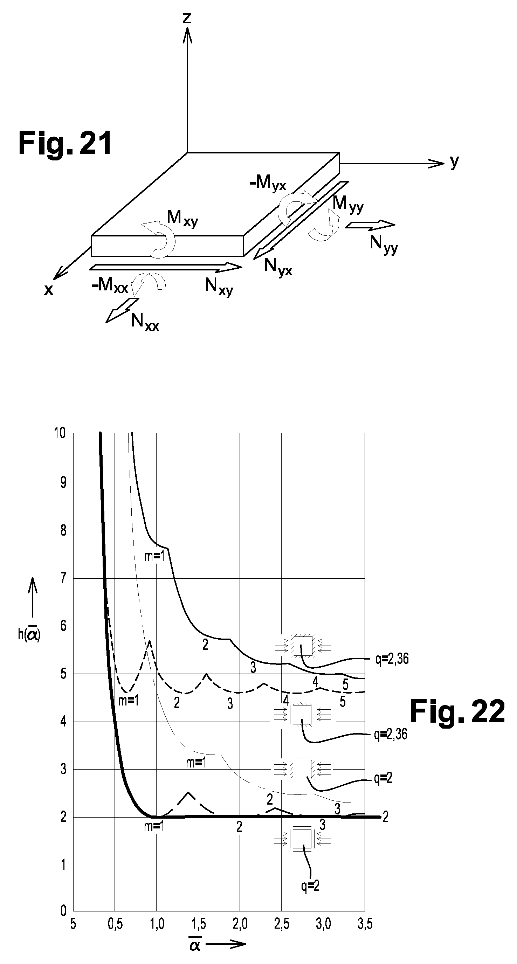

La présentation des cas de chargements envisagés est illustrée figure 21. Dans cette partie, trois modèles d'éléments finis ont été utilisés : trois plaques triangulaires isocèles avec des angles égaux à 45°, 60° et 70°. Pour chaque angle, l'étude est organisée en deux points :

### 1/ Calcul par Modèle Eléments Finis (FEM)

Pour toutes les combinaisons présentées ci-dessus, des calculs linéaires par méthode d'éléments finis ont été réalisés pour déterminer la valeur propre ("eigenvalue") de flambage correspondant à différentes répartitions de charges externes.

On constate que le premier mode observé présente toujours un seul cloquage.

Il apparaît que la courbe d'interaction est peu dépendante de la valeur de $\dfrac{D}{h^2}$ .

**2/Tracé des courbes d'interaction**

Pour chaque angle et chaque combinaison de charges, la courbe d'interaction est tracée. Ensuite ces différentes courbes ont été approximées avec des courbes classiques dont l'équation a la forme suivante :

$$R_1^{\ A} + R_2^{\ B} = 1$$

Avec $R_i = \dfrac{N_i^{\ app}}{N_i^{\ crit}}$ , i = cX, cY ou s.

Les résultats et les choix effectués ont montré que les équations des courbes d'interaction ne dépendent pas de l'angle de base du triangle isocèle et sont donc compatibles et peuvent être unifiées avec une unique équation couvrant toutes les combinaisons avec la forme suivante :

$$R_{cX}^{\ A} + R_{cY}^{\ B} + R_s^{\ C} = 1$$

A partir de cette équation, pour déterminer les facteurs de réserve, on résout l'équation suivante :

$$\left(\frac{R_{cY}}{R}\right)^A + \left(\frac{R_{cX}}{R}\right)^B + \left(\frac{R_s}{R}\right)^C = 1$$

avec

$$R = \frac{N_{cY}^{\ app}}{N_{cYcomb}^{\ crit}} = \frac{N_{cX}^{\ app}}{N_{cXcomb}^{\ crit}} = \frac{N_s^{\ app}}{N_{scomb}^{\ crit}} = \frac{1}{RF}$$

**5A.4 Facteur de correction de plasticité**

L'obtention d'une correction de plasticité pour les cas de chargement pur, fonction de l'angle isocèle et des conditions aux limites est très complexe. En fait, pour des plaques triangulaires, les fonctions de déflexion sont complexes et de nombreux problèmes d'intégration numériques se posent.

En conséquence, il est décidé d'utiliser un facteur η conservatif, sur la base du document NACA Report 898 ("A Unified Theory of Plastic Buckling of Columns and Plates", juillet 1947).

Ce facteur est défini pour tous les cas de chargement (pur et combiné) à l'exception du cisaillement, par :

$$\eta_5 = \frac{E_{\tan}}{E_c}$$

Et, pour les cas de chargement en cisaillement pur, par :

$$\eta_6 = \frac{(1+\nu_e)}{(1+\nu)} \cdot \frac{E_{\sec}}{E_c}$$

La correction est calculée en utilisant la contrainte élastique équivalente de Von Mises :

$$\sigma_{VM} = \sqrt{\sigma_{x\_comb}^{crit}{}^2 + \sigma_{y\_comb}^{crit}{}^2 - \sigma_{x\_comb}^{crit} \cdot \sigma_{y\_comb}^{crit} + 3 \cdot \tau_{xy\_comb}^{crit}{}^2}$$

Ainsi, les contraintes admissibles corrigées peuvent être calculées :

$$\sigma_{x\_comb}^{plast} = \eta \cdot \sigma_{x\_comb}^{crit}$$

$$\sigma_{y\_comb}^{plast} = \eta \cdot \sigma_{y\_comb}^{crit}$$

$$\tau_{xy\_comb}^{plast} = \eta \cdot \tau_{xy\_comb}^{crit}$$

Pour les cas de chargement pur (compression selon X, compression selon Y ou cisaillement), la correction de plasticité est également appliquée à la contrainte de Von Mises, donc pour les cas de charge de cisaillement pur, la contrainte corrigée est : $\sqrt{3} \cdot \tau_{xy}$ .

**5A.5 Plaques triangulaires isocèles en appui simple ("simply supported")**

**Cas de chargement pur**

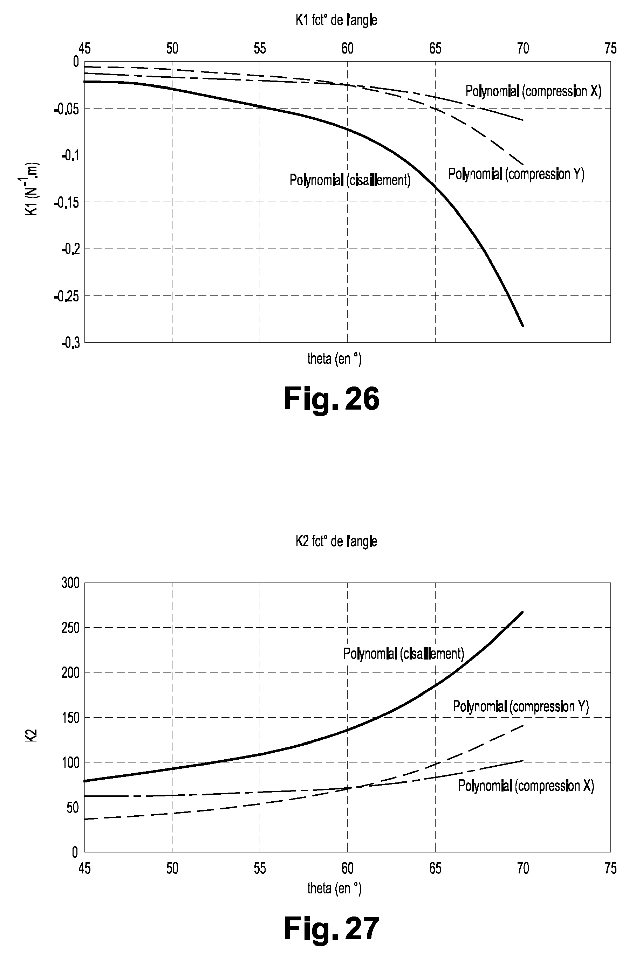

Dans les figures 26 et 27 sont présentées les évolutions des constantes $K_1$ et $K_2$ en fonction de l'angle isocèle. Les équations de ces courbes sont (avec $\theta$ en degrés):

$$K_{1cX} = -0.0000002417 \cdot \theta^4 + 0.0000504863 \cdot \theta^3 - 0.0039782194 \cdot \theta^2$$
$$+ 0.1393226958 \cdot \theta - 1.8379213492$$

$$K_{1cY} = -0.0000007200 \cdot \theta^4 + 0.0001511407 \cdot \theta^3 - 0.0119247778 \cdot \theta^2$$
$$+ 0.4177844180 \cdot \theta - 5.4796530159$$

$$K_{1s} = -0.0000018083 \cdot \theta^4 + 0.0003804181 \cdot \theta^3 - 0.0300743972 \cdot \theta^2$$
$$+ 1.0554840265 \cdot \theta - 13.8695053175$$

$$K_{2cX} = 0.0029565 \cdot \theta^3 - 0.4291321 \cdot \theta^2 + 21.1697836 \cdot \theta - 291.6730902$$

$$K_{2cY} = 0.0068664 \cdot \theta^3 - 1.0113413 \cdot \theta^2 + 51.3462358 \cdot \theta - 852.1945224$$

$$K_{2s} = 0.013637 \cdot \theta^3 - 2.017207 \cdot \theta^2 + 102.120039 \cdot \theta - 1674.287384$$

Que ce soit pour $K_1$ ou $K_2$, leurs valeurs en compression pure X et pure Y sont égales pour un angle isocèle de 60°. Le point d'intersection à 60° témoigne du comportement isotrope de la structure raidie par des poches triangulaires à 60°, en termes de flambage local de la peau.

**Cas de chargement combiné**

On réalise dans les cas de chargement combiné une analyse par modèle éléments finis de calcul linéaire de flambage pour des plaques triangulaires en appui simple. On choisit alors une courbe d'interaction conservative, proche des courbes d'interaction calculées, mais de formulation simple, qui devient la courbe utilisée dans le procédé décrit ici. Son équation est: $R_1{}^A + R_2{}^B = 1$. Avec $R_i = \dfrac{N_i{}^{app}}{N_i{}^{crit}}$, i = cX, cY ou s.

**Interaction compression X + compression Y (cas 1)**

Dans ce cas de chargement, pour les angles compris entre 45° et 70°, on choisit une courbe d'interaction conservative. C'est-à-dire une courbe déclarant une interaction à une valeur inférieure de la somme des compressions $R_{cX}$ sur X et $R_{cY}$ sur Y, vis-à-vis de toutes les courbes d'interaction calculées pour des valeurs angles compris entre 45° et 70°. Cette courbe est définie par l'équation suivante : $R_{cX} + R_{cY} = 1$

**Interaction compression X + cisaillement (cas 2)**

Dans ce cas de chargement, pour les angles compris entre 45° et 70°, on choisit une courbe d'interaction conservative, vis à vis des différentes courbes d'interaction selon les angles compris entre 45° et 70°, définie par l'équation suivante : $R_{cX} + R_s{}^{\frac{3}{2}} = 1$

**Interaction compression Y + cisaillement (cas 3)**

Pour les angles compris entre 45° et 70°, pour déterminer le facteur de réserve dans le cas de chargement combiné de compression selon Y et de cisaillement, on choisit une équation conservative de formule : $R_{cY} + R_s{}^2 = 1$. De manière à aboutir à une seule équation couvrant tous les cas de chargement, on choisit d'utiliser une autre courbe encore plus conservative

$$R_{cY} + R_s{}^{\frac{3}{2}} = 1$$

**Interaction compression X + compression Y + cisaillement (cas 4)**

3 L'équation choisie pour ce cas de charge est : $R_{cX} + R_{cY} + R_s{}^{\frac{3}{2}} = 1$. Cette unique équation est utilisée pour tous les cas de chargement combiné

**5A.6 Plaques triangulaires isocèles encastrées**

**Cas de chargement pur**

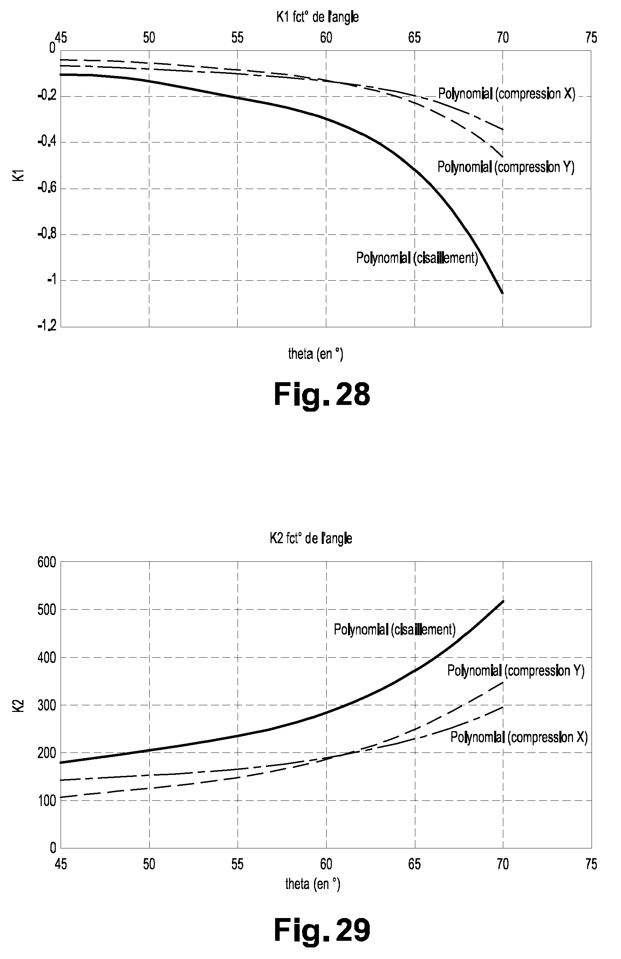

Dans les figures 28 et 29 sont présentées les évolutions des constantes $K_1$ et $K_2$ en fonction de l'angle isocèle. Les équations de ces courbes sont (avec θ en degrés):

$$K_{1cX} = -0.0000018547 \cdot \theta^4 + 0.0003940252 \cdot \theta^3 - 0.0314632778 \cdot \theta^2 + 1.1143937831 \cdot \theta - 14.8040153968$$

$$K_{1cY} = -0.0000027267 \cdot \theta^4 + 0.0005734489 \cdot \theta^3 - 0.0453489667 \cdot \theta^2 + 1.5921323016 \cdot \theta - 20.9299676191$$

$$K_{1s} = -0.0000069990 \cdot \theta^4 + 0.0014822211 \cdot \theta^3 - 0.1179080417 \cdot \theta^2$$
$$+ 4.1617623127 \cdot \theta - 54.9899559524$$

$$K_{2cX} = 0.0110488 \cdot \theta^3 - 1.6258419 \cdot \theta^2 + 81.8278420 \cdot \theta - 1254.6580819$$

$$K_{2cY} = 0.0158563 \cdot \theta^3 - 2.3439723 \cdot \theta^2 + 119.5038876 \cdot \theta - 1970.9532998$$

$$K_{2s} = 0.0252562 \cdot \theta^3 - 3.7563673 \cdot \theta^2 + 191.0642156 \cdot \theta - 3113.4527806$$

**Cas de chargement combiné**

On réalise dans les cas de chargement combiné une analyse par modèle éléments finis de calcul linéaire de flambage pour des plaques triangulaires encastrées. On choisit alors une courbe d'interaction conservative, proche des courbes d'interaction calculées, mais de formulation simple, qui devient la courbe utilisée dans le procédé décrit ici. Son

équation est : $R_1^A + R_2^B = 1$, avec $R_i = \dfrac{N_i^{app}}{N_i^{crit}}$ , i = cX, cY ou s.

**Interaction compression X + compression Y (cas 1)**

Dans ce cas de chargement, pour les angles compris entre 45° et 70°, on choisit une courbe d'interaction conservative, vis à vis des différentes courbes d'interaction selon les angles compris entre 45° et 70°, définie par l'équation suivante : $R_{cX} + R_{cY} = 1$

**Interaction compression X + cisaillement (cas 2)**

Dans ce cas de chargement, pour les angles compris entre 45° et 70°, on choisit une courbe d'interaction conservative, vis à vis des différentes courbes d'interaction selon les angles compris entre 45° et 70°, définie par l'équation suivante : $R_{cX} + R_s^{\frac{3}{2}} = 1$

**Interaction compression Y + cisaillement (cas 3)**

Pour les angles compris entre 45° et 70°, pour déterminer le facteur de réserve dans le cas de chargement combiné de compression selon Y et de cisaillement, on choisit une équation conservative de formule : $R_{cY} + R_s^2 = 1$. De manière à aboutir à une seule équation couvrant tous les cas de chargement, on choisit d'utiliser une autre courbe encore plus conservative

$$R_{cY} + R_s^{\frac{3}{2}} = 1$$

**Interaction : compression X + compression Y + cisaillement (cas 4)**

L'équation, utilisée pour ce cas de charge, est $R_{cX} + R_{cY} + R_s^{\frac{3}{2}} = 1$ . Cette unique équation est utilisée pour tous les cas de chargement combiné.

**5B Calcul de flambage local de raidisseur :**

Ce module calcule la contrainte de flambage et le facteur de réserve de l'âme ("blade") du raidisseur, considéré comme un panneau rectangulaire avec diverses conditions aux limites à définir par l'utilisateur.
Les contraintes appliquées à prendre en compte pour les calculs de facteur de réserve sont les contraintes dans les âmes des raidisseurs seulement, provenant du module de calcul des contraintes appliquées.

Sur la grille de raidisseurs, un ou plusieurs types d'âmes des raidisseurs sont chargés en compression. De ce fait, la contrainte de compression admissible doit être calculée.

Les données d'entrée de ce module sont :

- Données géométriques : dimensions des âmes des raidisseurs (longueur, hauteur, épaisseur),
- Données de matériau (linéaire (E, v) et non-linéaire ($F_{cy}$, $F_{tu}$, $\varepsilon_{ult}$, $n_c$)). On considère dans le présent exemple un matériau isotrope seulement,
- conditions aux limites (quatre sont disponibles),
- charges appliquées sur les âmes des raidisseurs.

Les données de sortie sont le flambage admissible de l'âme du raidisseur et un facteur de réserve. La contrainte de flambage admissible de l'âme du raidisseur est (voir figure 13 pour les conventions de notation) :

$$\sigma_{blade}^{crit} = k_c \cdot \frac{\eta \cdot E_c \cdot \pi^2}{12 \cdot \left(1 - v_e^2\right)} \cdot \left(\frac{b}{d}\right)^2$$

## Equation 5-2

Avec:

    b: épaisseur de l'âme des raidisseurs
    d: hauteur de l'âme des raidisseurs
    $L_b$: longueur de l'âme des raidisseurs
    $E_c$: Module d'Young en compression
    $v_e$: Coefficient de Poisson dans le domaine élastique
    $k_c$: Facteur de flambage local (dépendant des conditions aux limites et de la géométrie)
    $\eta$: Facteur de correction de plasticité

Note: la longueur d'une âme de raidisseur est donnée par

( $L_b$) = a (pour les âmes des raidisseurs dans la direction X) $(L_b) = \frac{a}{2} \cdot \sqrt{1 + \tan^2 \theta}$ (pour les âmes des raidisseurs dans les directions transverses)

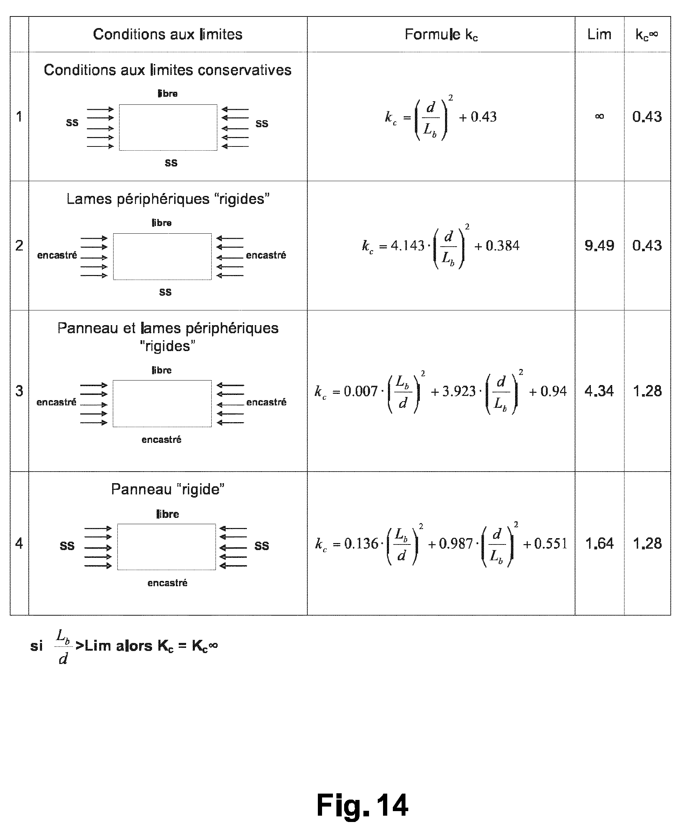

De nombreuses conditions aux limites peuvent être appliquées sur l'âme de raidisseur en fonction de la structure environnante. (voir figure 14). On note que si Lb/d est supérieur à la valeur Lim, alors $k_c$ vaut $k_c$ infini. Le facteur de flambage conservatif recommandé pour les calculs basés sur de nombreuses analyses par éléments finis est le cas 2 (2 bords encastrés - 1 bord en appui simple - 1 bord libre).

Selon les conditions aux limites citées plus haut et selon la table 1 de facteur de correction plastique pour des plaques rectangulaires, le facteur de correction de plasticité utilisé dans ce cas est :

$$\eta = \eta_1 = \frac{E_{sec}}{E_c} \cdot \frac{1 - v_e^2}{1 - v^2}$$

La formule pour le calcul de facteur de réserve pour le flambage de l'âme de raidisseur est valide pour tous les types d'âmes de raidisseurs utilisés dans le présent panneau raidi par des poches triangulaires (0°, + $\theta$, -$\theta$):

$$RF_{buck}^{blade} = \frac{\sigma_{blade}^{crit}}{\sigma_{blade}^{app}}$$

L'exemple suivant est basé sur la même géométrie que dans les parties précédentes. La géométrie des raidisseurs est : b = 2.5 mm, et d = 37.36 mm. La longueur des âmes des raidisseurs est (L_b) : $L_b$ = a = 198mm pour les âmes des raidisseurs dans la direction X et $L_b = \dfrac{a}{2} \cdot \sqrt{1 + \tan^2 \theta}$ = 186.82 mm pour les âmes des raidisseurs transverses. Les conditions aux limites utilisées sont : 2 bords encastrés - 1 bord en appui simple - 1 bord libre.

Ainsi : $k_{c\_0°} = 4.143 \cdot \left(\dfrac{d}{L_b}\right)^2 + 0.384 = 0.5315$ pour les âmes des raidisseurs dans la direction X, et

$$k_{c\_\theta°} = 4.143 \cdot \left(\dfrac{d}{L_b}\right)^2 + 0.384 = 0.5497$$ pour les âmes des raidisseurs transverses

Et la charge de flambage pour chaque raidisseur est :

$$\sigma_{blade\_0°}^{crit} = k_{c\_0°} \cdot \frac{\eta \cdot E_c \cdot \pi^2}{12 \cdot \left(1 - v_e^2\right)} \cdot \left(\frac{b}{d}\right)^2 = 167.78\,MPa$$

$$\sigma_{blade\_\theta°}^{crit} = k_{c\_\theta°} \cdot \frac{\eta \cdot E_c \cdot \pi^2}{12 \cdot \left(1 - v_e^2\right)} \cdot \left(\frac{b}{d}\right)^2 = 173.52\,MPa$$

Au flambage de l'âme de raidisseur, le facteur de correction de plasticité est :

$$\eta = \eta_1 = \frac{E_{sec}}{E_c} \cdot \frac{1 - v_e^2}{1 - v^2} = 1 \text{ (élastique)}$$

Les charges appliquées dans les raidisseurs sont :

$$\sigma_{0°} = -101.14\,MPa$$

$$\sigma_{+\theta} = 44.25\,MPa$$

$$\sigma_{-\theta} = -135.07\,MPa$$

Les résultats du calcul de facteur de réserve sont les suivants :

$$RF_{buck}^{blade\_0°} = \frac{\sigma_{blade\_0°}^{crit}}{\sigma_{blade\_0°}^{app}} = 1.61$$

$$RF_{buck}^{blade\_+\theta°} = \frac{\sigma_{blade\_\theta°}^{crit}}{\sigma_{blade\_+\theta°}^{app}} \Rightarrow pas\_de\_gauchissement$$

$$RF_{buck}^{blade\_-\theta^\circ} = \frac{\sigma_{blade\_\theta^\circ}^{crit}}{\sigma_{blade\_-\theta^\circ}^{app}} = 1.28$$

**Etape 6 - Calcul d'instabilité générale** :

Cette étape fournit des données de flux admissible de flambage pour un panneau plat raidi par des poches triangulaires, dans des conditions de chargement pur ou combiné.

Les formules sont basées sur le flambage de plaques orthotropes. Deux ou quatre conditions aux limites sont possibles selon le cas de chargement (4 bords en appui simple, 4 bords encastrés, 2 bords chargés en appui simple et 2 bords latéraux encastrés, 2 bords chargés encastrés et 2 bords latéraux en appui simple). Les flux appliqués, à prendre en compte pour le calcul de facteur de réserve sont les flux externes du panneau raidi par des poches triangulaires, qui sont des données d'entrée.

Les données d'entrée sont les suivantes :

• Données géométriques:

  ◦ $L_x$ : longueur du panneau équivalent à la grille,
  ◦ $L_y$ : largeur du panneau équivalent à la grille,
  ◦ $t_s$ : épaisseur de la peau,
  ◦ $t_g$ : épaisseur du panneau équivalent à la grille,

• Données sur le matériau :

  ◦ $E_x^s$ , $E_y^s$ : modules d' Young de la peau,
  ◦ $G_{xy}^s$ : module de cisaillement de la peau,
  ◦ $v_{xy}^s$, $v_{yx}^s$ : coefficient de Poisson de la peau,
  ◦ $E_x^g$, $E_y^g$ : modules d'Young de la grille,
  ◦ $G_{xy}^g$ : module de cisaillement de la grille,
  ◦ $v_{xy}^g$, $v_{yx}^g$ : coefficient de Poisson de la grille,

• charges appliquées à la structure ($N_x^0$, $N_y^0$, $N_{xy}^0$, $p_z$)
• conditions aux limites (2 ou 4 sont possibles selon le type de chargement)

Les données de sortie sont :

• $N_x^c$, $N_y^c$, $N_{xy}^c$ : flux de flambage admissibles,
• $N_x^c{}_{comb}$, $N_y^c{}_{comb}$, $N_{xy}^c{}_{comb}$ : flux de flambage combinés admissibles,
• Facteurs de réserve

On utilise l'hypothèse de Kirchhoff : des sections planes demeurent principalement planes après déformation. La grille (de raidisseurs) est ici modélisée par un panneau équivalent. La peau et le panneau équivalent à la grille sont considérés comme des plaques de comportement orthotrope.

Les paramètres du matériau vérifient la relation suivante $\dfrac{v_{xy}^i}{E_x^i} = \dfrac{v_{yx}^i}{E_y^i}$

Les conventions de flux et moments sont illustrées par la figure 21.

**6.1.1 Déplacements**

Le vecteur $\vec{U}$ représente le déplacement d'un point $M(x,y)$ de la surface médiane $\vec{U}$ = $[u,v,w] = u(x,y)\vec{x} + v(x,y)\vec{y} + w(x,y)\vec{z}$

Les différentes variables ne dépendent pas de z parce qu'un état de contraintes plan a été envisagé ($\sigma_{zz}$ = 0).

**6.1.2 Déformations**

L'expression générale des déformations dans une section de la plaque située à une distance z de l'axe médian est :

$$\begin{cases} \varepsilon_{xx} = \varepsilon_{xx}^0 + z.\kappa_{xx} \\ \varepsilon_{yy} = \varepsilon_{yy}^0 + z.\kappa_{yy} \\ \varepsilon_{xy} = \varepsilon_{xy}^0 + z.\kappa_{xy} \end{cases}$$

## Equation 6-1

Avec:

$$\begin{cases} \varepsilon_{xx}^0 = u_{,x} + \frac{1}{2}\left(w_{,x}\right)^2 \\ \varepsilon_{yy}^0 = v_{,y} + \frac{w}{R} + \frac{1}{2}\left(w_{,y}\right)^2 \\ \varepsilon_{xy}^0 = \frac{1}{2}\left(u_{,y} + v_{,x}\right) + \frac{1}{2}w_{,x}.w_{,y} \end{cases}$$

## Equation 6-2

Les termes $\varepsilon_{xx}^0$ , $\varepsilon_{yy}^0$ et $\varepsilon_{xy}^0$ représentent la contribution en déformation dans le plan de la plaque. Les termes $\frac{1}{2}\left(w_{,x}\right)^2$ , $\frac{1}{2}\left(w_{,y}\right)^2$ et $\frac{1}{2}w_{,x}.w_{,y}$ représentent la contribution non-linéaire en déformation dans le plan de la plaque.

Le terme R représente le rayon de la coque ("shell"), mais on considère ici une plaque plane, donc $\frac{1}{R} = 0$ .

$$\begin{cases} \kappa_{xx} = -w_{,x^2} \\ \kappa_{yy} = -w_{,y^2} \\ \kappa_{xy} = -w_{,xy} \end{cases}$$

## Equation 6-3

Les termes $z.\kappa_{xx}$, $z.\kappa_{yy}$ et $z.\kappa_{xy}$ représentent la contribution en déformation due au changement de courbe de la plaque (z est la distance depuis l'axe médian de la plaque).

**6.1.3 Lois de comportement**

La peau et le panneau équivalent aux raidisseurs sont considérés comme des plaques orthotropes. De ce fait les relations entre les contraintes et les déformations sont :

$$
\begin{pmatrix} \sigma_{xx}^i \\ \sigma_{yy}^i \\ \sigma_{xy}^i \end{pmatrix} = \begin{pmatrix} \dfrac{E_x^i}{1-\nu_{xy}^i \nu_{yx}^i} & \dfrac{\nu_{xy}^i E_y^i}{1-\nu_{xy}^i \nu_{yx}^i} & 0 \\[2ex] \dfrac{\nu_{yx}^i E_x^i}{1-\nu_{xy}^i \nu_{yx}^i} & \dfrac{E_y^i}{1-\nu_{xy}^i \nu_{yx}^i} & 0 \\[2ex] 0 & 0 & 2G_{xy}^i \end{pmatrix} \begin{pmatrix} \varepsilon_{xx} \\ \varepsilon_{yy} \\ \varepsilon_{xy} \end{pmatrix}
$$

## Equation 6-4

avec $i=(s,\ g)$ (indice $s$ pour les valeurs relatives à la peau et indice $g$ pour les valeurs relative à la grille de raidisseurs).

### 6.1.4 Flux et moments

Les expressions des flux et moments par unité de longueur sont :

$$
N_{\alpha\beta} = \int_h \sigma_{\alpha\beta} dz
$$

$$
M_{\alpha\beta} = \int_h \sigma_{\alpha\beta}.zdz
$$

## Equation 6-5

avec $(a,\beta)=(x,y)$.

• **Flux:**

$$
N_{\alpha\beta} = \int_h \sigma_{\alpha\beta} dz = \int_{-\frac{h}{2}}^{-\frac{h}{2}+t_s} \sigma_{\alpha\beta}^s dz + \int_{-\frac{h}{2}+t_s}^{\frac{h}{2}} \sigma_{\alpha\beta}^g dz
$$

En utilisant l'Equation 6-5 et la relation $h = t_s + t_g$ on trouve :

$$N_{xx} = \left( \frac{E_x^s t_s}{1 - \nu_{xy}^s \nu_{yx}^s} + \frac{E_x^g t_g}{1 - \nu_{xy}^g \nu_{yx}^g} \right) \varepsilon_{xx}^0 + \left( \frac{\nu_{xy}^s E_y^s t_s}{1 - \nu_{xy}^g \nu_{yx}^g} + \frac{\nu_{xy}^g E_y^g t_g}{1 - \nu_{xy}^g \nu_{yx}^g} \right) \varepsilon_{yy}^0$$

$$+ \left[ \frac{1}{2} t_s t_g \left( \frac{E_x^g}{1 - \nu_{xy}^g \nu_{yx}^g} - \frac{E_x^s}{1 - \nu_{xy}^s \nu_{yx}^s} \right) \right] \kappa_{xx} + \left[ \frac{1}{2} t_s t_g \left( \frac{\nu_{xy}^g E_y^g}{1 - \nu_{xy}^g \nu_{yx}^g} - \frac{\nu_{xy}^s E_y^s}{1 - \nu_{xy}^g \nu_{yx}^g} \right) \right] \kappa_{yy}$$

$$N_{yy} = \left( \frac{\nu_{yx}^s E_x^s t_s}{1 - \nu_{xy}^g \nu_{yx}^g} + \frac{\nu_{yx}^g E_x^g t_g}{1 - \nu_{xy}^g \nu_{yx}^g} \right) \varepsilon_{xx}^0 + \left( \frac{E_y^s t_s}{1 - \nu_{xy}^s \nu_{yx}^s} + \frac{E_y^g t_g}{1 - \nu_{xy}^g \nu_{yx}^g} \right) \varepsilon_{yy}^0$$

$$+ \left[ \frac{1}{2} t_s t_g \left( \frac{\nu_{yx}^g E_x^g}{1 - \nu_{xy}^g \nu_{yx}^g} - \frac{\nu_{yx}^s E_x^s}{1 - \nu_{xy}^g \nu_{yx}^g} \right) \right] \kappa_{xx} + \left[ \frac{1}{2} t_s t_g \left( \frac{E_y^g}{1 - \nu_{xy}^g \nu_{yx}^g} - \frac{E_y^s}{1 - \nu_{xy}^s \nu_{yx}^s} \right) \right] \kappa_{yy}$$

$$N_{xy} = 2 \left( G_{xy}^s t_s + G_{xy}^g t_g \right) \varepsilon_{xy}^0 + \left[ t_s t_g \left( G_{xy}^g - G_{xy}^s \right) \right] \kappa_{xy}$$

## Equation 6-6

• **Moments par unité de longueur :**

$$M_{\alpha\beta} = \int_h \sigma_{\alpha\beta} z \, dz = \int_{-\frac{h}{2}}^{-\frac{h}{2}+t_s} \sigma_{\alpha\beta}^s z \, dz + \int_{-\frac{h}{2}+t_s}^{\frac{h}{2}} \sigma_{\alpha\beta}^g z \, dz$$

En utilisant l'Equation 6-5 et la relation $h = t_s + t_g$ on trouve :

$$- M_{xx} = \left[ \frac{1}{2} t_s t_g \left( \frac{E_x^g}{1 - \nu_{xy}^g \nu_{yx}^g} - \frac{E_x^s}{1 - \nu_{xy}^s \nu_{yx}^s} \right) \right] \varepsilon_{xx}^0 + \left[ \frac{1}{2} t_s t_g \left( \frac{\nu_{xy}^g E_y^g}{1 - \nu_{xy}^g \nu_{yx}^g} - \frac{\nu_{xy}^s E_y^s}{1 - \nu_{xy}^g \nu_{yx}^g} \right) \right] \varepsilon_{yy}^0$$

$$+ \left[ \frac{1}{12} \left( \frac{E_x^s t_s \left( t_s^2 + 3 t_g^2 \right)}{1 - \nu_{xy}^s \nu_{yx}^s} + \frac{E_x^g t_g \left( t_g^2 + 3 t_s^2 \right)}{1 - \nu_{xy}^g \nu_{yx}^g} \right) \right] \kappa_{xx}$$

$$+ \left[ \frac{1}{12} \left( \frac{\nu_{xy}^s E_y^s t_s \left( t_s^2 + 3 t_g^2 \right)}{1 - \nu_{xy}^g \nu_{yx}^g} + \frac{\nu_{xy}^g E_y^g t_g \left( t_g^2 + 3 t_s^2 \right)}{1 - \nu_{xy}^g \nu_{yx}^g} \right) \right] \kappa_{yy}$$

$$M_{yy} = \left[\frac{1}{2}t_s t_g \left(\frac{v_{yx}^g E_x^g}{1-v_{xy}^g v_{yx}^g} - \frac{v_{yx}^s E_x^s}{1-v_{xy}^s v_{yx}^s}\right)\right]\varepsilon_{xx}^0 + \left[\frac{1}{2}t_s t_g \left(\frac{E_y^g}{1-v_{xy}^g v_{yx}^g} - \frac{E_y^s}{1-v_{xy}^s v_{yx}^s}\right)\right]\varepsilon_{yy}^0$$

$$+ \left[\frac{1}{12}\left(\frac{v_{yx}^s E_x^s t_s \left(t_s^2 + 3t_g^2\right)}{1-v_{xy}^g v_{yx}^g} + \frac{v_{yx}^g E_x^g t_g \left(t_g^2 + 3t_s^2\right)}{1-v_{xy}^g v_{yx}^g}\right)\right]\kappa_{xx}$$

$$+ \left[\frac{1}{12}\left(\frac{E_y^s t_s \left(t_s^2 + 3t_g^2\right)}{1-v_{xy}^s v_{yx}^s} + \frac{E_y^g t_g \left(t_g^2 + 3t_s^2\right)}{1-v_{xy}^g v_{yx}^g}\right)\right]\kappa_{yy}$$

$$- M_{xy} = \left[t_s t_g \left(G_{xy}^g - G_{xy}^s\right)\right]\varepsilon_{xy}^0 + \left[\frac{1}{6}\left(G_{xy}^s t_s \left(t_s^2 + 3t_g^2\right) + G_{xy}^g t_g \left(t_g^2 + 3t_s^2\right)\right)\right]\kappa_{xy}$$

**Equation 6-7**

Dès lors, la loi de comportement générale (entre flux et moments d'une part, et déformations, d'autre part), est obtenue :

$$\begin{pmatrix} N_{xx} \\ N_{yy} \\ N_{xy} \\ -M_{xx} \\ M_{yy} \\ -M_{xy} \end{pmatrix} = \left(\begin{array}{c|c} \overline{\overline{\mathbf{A}}} & \overline{\overline{\mathbf{B}}} \\ \hline \overline{\overline{\mathbf{B}}} & \overline{\overline{\mathbf{C}}} \end{array}\right) \cdot \begin{pmatrix} \varepsilon_{xx}^0 \\ \varepsilon_{yy}^0 \\ \varepsilon_{xy}^0 \\ \kappa_{xx} \\ \kappa_{yy} \\ \kappa_{xy} \end{pmatrix} = \begin{pmatrix} A_{11} & A_{12} & 0 & B_{11} & B_{12} & 0 \\ A_{12} & A_{22} & 0 & B_{12} & B_{22} & 0 \\ 0 & 0 & A_{11} & 0 & 0 & B_{33} \\ B_{11} & B_{12} & 0 & C_{11} & C_{12} & 0 \\ B_{12} & B_{11} & 0 & C_{12} & C_{22} & 0 \\ 0 & 0 & B_{33} & 0 & 0 & C_{33} \end{pmatrix} \cdot \begin{pmatrix} \varepsilon_{xx}^0 \\ \varepsilon_{yy}^0 \\ \varepsilon_{xy}^0 \\ \kappa_{xx} \\ \kappa_{yy} \\ \kappa_{xy} \end{pmatrix}$$

**Equation 6-8**

Les matrices **A, B** et **C** sont symétriques.

### 6.2 Equations d'équilibre

**Les équations d'équilibre général** d'un élément du panneau (ou coque) sont données par les expressions suivantes, reliant les flux, moments et la densité de forces de surface :

$$\begin{cases} N_{xx,x} + N_{xy,y} + p_x = 0 \\ N_{yy,y} + N_{yx,x} + p_y = 0 \\ (N_{xx}w_{,x})_{,x} + (N_{yy}w_{,y})_{,y} + (N_{xy}w_{,y})_{,x} + (N_{yx}w_{,x})_{,y} - \dfrac{N_{yy}}{R} - M_{xx,x^2} + M_{yy,y^2} - 2M_{xy,xy} + p_z = 0 \end{cases}$$

**Equation 6-9**

où $\vec{f} = p_x \vec{x} + p_y \vec{y} + p_z \vec{z}$ est la densité de forces de surface agissant sur l'élément de coque. La densité de force de surface agit seulement le long de la direction radiale Z, et non dans les autres directions. Donc, $p_x = p_y = 0$. Par ailleurs, on considère ici le cas d'une plaque plate, donc $\dfrac{1}{R} = 0$. De ce fait, on obtient des **équations d'équilibre simplifiées :**

$$\begin{cases} N_{xx,x} + N_{xy,y} = 0 \\ N_{yy,y} + N_{yx,x} = 0 \\ N_{xx}w_{,x^2} + N_{yy}w_{,y^2} + 2N_{xy}w_{,xy} + p_z = M_{xx,x^2} - M_{yy,y^2} + 2M_{xy,xy} \end{cases}$$

## Equation 6-10

**6.3 Pour la résolution générale** de ces équations, on définit les vecteurs suivants :

$$[\boldsymbol{\varepsilon}] = \begin{bmatrix} \varepsilon_{xx} \\ \varepsilon_{yy} \\ \varepsilon_{xy} \end{bmatrix} \quad [\mathbf{N}] = \begin{bmatrix} N_{xx} \\ N_{yy} \\ N_{xy} \end{bmatrix} \quad [\mathbf{K}] = \begin{bmatrix} \kappa_{xx} \\ \kappa_{yy} \\ \kappa_{xy} \end{bmatrix} \quad [\mathbf{W}] = \begin{bmatrix} w_{,xx} \\ w_{,yy} \\ w_{,xy} \end{bmatrix} \quad [\mathbf{M}] = \begin{bmatrix} -M_{xx} \\ M_{yy} \\ -M_{xy} \end{bmatrix}$$

## Equation 6-11

Les charges usuelles appliquées sur la plaque sont :

- Flux de compression uniforme le long de l'axe $x : -N_x^0$
- Flux de compression uniforme le long de l'axe $y : -N_y^0$
- Flux de cisaillement uniforme dans le plan $x\text{-}y : -N_{xy}^0$
- Pression uniforme le long de l'axe z : $p_z\bar{z}$

De ce fait, comme les charges appliquées définies ci-dessus sont uniformes, il peut être déduit que les deux premières équations de l'Equation 6-10 sont vérifiées: $N_{xx,x} = N_{yy,y} = N_{xy,y} = N_{yx,x} = 0$.

**Expression des Moments:**

En utilisant les Equation 6-8 et Equation 6-11, les relations suivantes sont trouvées :

$$[\mathbf{N}] = \overline{\overline{\mathbf{A}}}.[\boldsymbol{\varepsilon}] + \overline{\overline{\mathbf{B}}}.[\mathbf{K}]$$
$$[\mathbf{M}] = \overline{\overline{\mathbf{B}}}.[\boldsymbol{\varepsilon}] + \overline{\overline{\mathbf{C}}}.[\mathbf{K}]$$

## Equation 6-12

Comme les flux appliqués sont uniformes, les relations suivantes sont obtenues :

$$\left[\mathbf{N}\right]_{,x^2} = 0 \quad \Leftrightarrow \quad \overline{\overline{\mathbf{A}}}.\left[\boldsymbol{\varepsilon}\right]_{,x^2} + \overline{\overline{\mathbf{B}}}.\left[\mathbf{K}\right]_{,x^2} = 0 \quad \Leftrightarrow \quad \left[\boldsymbol{\varepsilon}\right]_{,x^2} = \overline{\overline{\mathbf{A}}}^{-1}.\overline{\overline{\mathbf{B}}}.\left[\mathbf{W}\right]_{,x^2}$$

$$\left[\mathbf{N}\right]_{,y^2} = 0 \quad \Leftrightarrow \quad \overline{\overline{\mathbf{A}}}.\left[\boldsymbol{\varepsilon}\right]_{,y^2} + \overline{\overline{\mathbf{B}}}.\left[\mathbf{K}\right]_{,y^2} = 0 \quad \Leftrightarrow \quad \left[\boldsymbol{\varepsilon}\right]_{,y^2} = \overline{\overline{\mathbf{A}}}^{-1}.\overline{\overline{\mathbf{B}}}.\left[\mathbf{W}\right]_{,y^2}$$

$$\left[\mathbf{N}\right]_{,xy} = 0 \quad \Leftrightarrow \quad \overline{\overline{\mathbf{A}}}.\left[\boldsymbol{\varepsilon}\right]_{,xy} + \overline{\overline{\mathbf{B}}}.\left[\mathbf{K}\right]_{,xy} = 0 \quad \Leftrightarrow \quad \left[\boldsymbol{\varepsilon}\right]_{,xy} = \overline{\overline{\mathbf{A}}}^{-1}.\overline{\overline{\mathbf{B}}}.\left[\mathbf{W}\right]_{,xy}$$

**Equation 6-13**

Avec le fait que : [W] = -[K].

On a donc pour les moments :

$$\left[\mathbf{M}\right]_{,x^2} = \overline{\overline{\mathbf{B}}}.\left[\boldsymbol{\varepsilon}\right]_{,x^2} + \overline{\overline{\mathbf{C}}}.\left[\mathbf{K}\right]_{,x^2} = \left(\overline{\overline{\mathbf{B}}}.\overline{\overline{\mathbf{A}}}^{-1}.\overline{\overline{\mathbf{B}}} - \overline{\overline{\mathbf{C}}}\right).\left[\mathbf{W}\right]_{,x^2} = -\overline{\overline{\mathbf{D}}}.\left[\mathbf{W}\right]_{,x^2}$$

$$\left[\mathbf{M}\right]_{,y^2} = \overline{\overline{\mathbf{B}}}.\left[\boldsymbol{\varepsilon}\right]_{,y^2} + \overline{\overline{\mathbf{C}}}.\left[\mathbf{K}\right]_{,y^2} = \left(\overline{\overline{\mathbf{B}}}.\overline{\overline{\mathbf{A}}}^{-1}.\overline{\overline{\mathbf{B}}} - \overline{\overline{\mathbf{C}}}\right).\left[\mathbf{W}\right]_{,y^2} = -\overline{\overline{\mathbf{D}}}.\left[\mathbf{W}\right]_{,y^2}$$

$$\left[\mathbf{M}\right]_{,xy} = \overline{\overline{\mathbf{B}}}.\left[\boldsymbol{\varepsilon}\right]_{,xy} + \overline{\overline{\mathbf{C}}}.\left[\mathbf{K}\right]_{,xy} = \left(\overline{\overline{\mathbf{B}}}.\overline{\overline{\mathbf{A}}}^{-1}.\overline{\overline{\mathbf{B}}} - \overline{\overline{\mathbf{C}}}\right).\left[\mathbf{W}\right]_{,xy} = -\overline{\overline{\mathbf{D}}}.\left[\mathbf{W}\right]_{,xy}$$

**Equation 6-14**

avec

$$\overline{\overline{\mathbf{D}}} = \overline{\overline{\mathbf{C}}} - \overline{\overline{\mathbf{B}}}.\overline{\overline{\mathbf{A}}}^{-1}.\overline{\overline{\mathbf{B}}}$$

**Equation 6-15**

**D** est la matrice de raideur globale, et est symétrique.

$$\overline{\overline{\mathbf{D}}} = \begin{pmatrix} D_{11} & D_{12} & 0 \\ D_{12} & D_{22} & 0 \\ 0 & 0 & D_{33} \end{pmatrix}$$

Les dérivées des moments de l'Equation 6-10 sont alors obtenues :

$$M_{xx,x^2} = D_{11}w_{,x^4} + D_{12}w_{,x^2y^2}$$

$$-M_{yy,y^2} = D_{12}w_{,x^2y^2} + D_{22}w_{,y^4}$$

$$M_{xy,xy} = D_{33}w_{,x^2y^2}$$

**Equation 6-16**

L'expression de l'Equation 6-10 en termes de déplacements donne alors **l'équation différentielle générale :**

$$-N_x^0 w_{,x^2} - N_y^0 w_{,y^2} - 2N_{xy}^0 w_{,xy} + p_z = \Omega_1 w_{,x^4} + \Omega_2 w_{,y^4} + \Omega_3 w_{,x^2y^2}$$

**Equation 6-17**

41

avec :

$$\Omega_1 = D_{11}$$
$$\Omega_2 = D_{22}$$
$$\Omega_3 = 2 \cdot (D_{12} + D_{33})$$

## Equation 6-18

Dans la partie suivante, le panneau raidi par des poches triangulaires est modélisé avec ses trois raideurs de flexion ($\Omega$1, $\Omega$2 et $\Omega$3) de façon à calculer les flux de flambage d'une plaque orthotrope.

Ici encore, on utilise dans ce cas l'hypothèse suivante : si certains composants de la charge combinée sont en tension, alors ces composants ne sont pas pris en compte pour le calcul. Il est en effet conservatif de considérer que des composants en tension n'ont pas d'effet vis à vis du flux de flambage étudié, et n'améliorent pas la contrainte de flambage de la plaque.

### 6.4 Flux de flambage admissibles

### 6.4.1 Flux de compression longitudinale (compression selon X)

La plaque est soumise à un flux de compression longitudinal (selon l'axe X) uniforme : $-N_x^0$. De ce fait : $N_y^0 = N_{xy}^0 = p_z = 0$. L'équation différentielle générale (Equation 6-17) s'exprime alors :

$$-N_x^0 w_{,x^2} = \Omega_1 w_{,x^4} + \Omega_2 w_{,y^4} + \Omega_3 w_{,x^2 y^2}$$

## Equation 6-19

On considère dans un premier temps une plaque en appui simple (les conditions aux limites sont généralisées plus loin):

Pour $x = 0$ et $x = L_x$ : $w = 0$ et $- M_{xx} = 0$
Pour $y = 0$ et $y = L_y$ : $w = 0$ et $M_{yy} = 0$

L'expression suivante pour le déplacement $w$ satisfait toutes les conditions aux limites détaillées plus haut :

$$w(x, y) = C_{mn} \sin\left(\frac{m\pi x}{L_x}\right) \sin\left(\frac{n\pi y}{L_y}\right) \quad (m, n) \in \mathbf{N}^2$$

## Equation 6-20

L'expression précédente pour w doit satisfaire l'équation différentielle générale (Equation 6-19), donc on obtient :

$$N_x^0 \left(\frac{m\pi}{L_x}\right)^2 = \Omega_1 \left(\frac{m\pi}{L_x}\right)^4 + \Omega_2 \left(\frac{n\pi}{L_y}\right)^4 + \Omega_3 \left(\frac{m\pi}{L_x}\right)^2 \left(\frac{n\pi}{L_y}\right)^2 \quad (m, n) \in \mathbf{N}^2$$

La valeur minimale de $N_x^0$ correspond à la valeur du flux admissible de flambage général $N_x^c$. On démontre que cette valeur est :

$$N_x^c = 2\left(\frac{\pi}{L_y}\right)^2\left(\sqrt{\Omega_1\Omega_2} + \frac{\Omega_3}{2}\right)$$

## Equation 6-21

Cette formule peut être généralisée pour différentes conditions aux limites (bord chargés et bords latéraux en appui simple ou encastrés) :

$$N_x^c = k_c\left(\frac{\pi}{L_y}\right)^2\sqrt{\Omega_1\Omega_2}$$

## Equation 6-22

avec

$$k_c = h(\overline{\alpha}) + q.\beta$$

$$\overline{\alpha} = \frac{L_x}{L_y}\sqrt[4]{\frac{\Omega_2}{\Omega_1}}$$

$$\beta = \frac{\Omega_3}{2\sqrt{\Omega_1\Omega_2}}$$

$$h(\overline{\alpha}) = \begin{cases} \left(\frac{1}{\overline{\alpha}}\right)^2 + \overline{\alpha}^2, & si\,\overline{\alpha} \leq 1 \\ 2 & , \quad \sin on \end{cases}$$

$$q = 2$$

La figure 22 montre la valeur de $h(\overline{\alpha})$ en fonction des différentes conditions aux limites (le cas des quatre bords simplement supportés est la courbe du bas).

### 6.4.2 Flux de compression transversale (compression selon Y)

La plaque est soumise à un flux de compression uniforme transversal (selon l'axe Y) : $-N_y^0$. De ce fait :

$N_x^0 = N_{xy}^0 = p_z = 0$. La résolution est analogue à celle qui a été décrite dans la partie précédente.

Le flux de flambage admissible $N_y^c$ s'exprime par :

$$N_y^c = k_c\left(\frac{\pi}{L_x}\right)^2\sqrt{\Omega_2\Omega_1}$$

## Equation 6-23

avec

$$k_c = h(\overline{\alpha}) + q.\beta$$

$$\overline{\alpha} = \frac{L_y}{L_x} \sqrt[4]{\frac{\Omega_1}{\Omega_2}}$$

$$\beta = \frac{\Omega_3}{2\sqrt{\Omega_2 \Omega_1}}$$

$$h(\overline{\alpha}) = \begin{cases} \left(\frac{1}{\overline{\alpha}}\right)^2 + \overline{\alpha}^2, & si\ \overline{\alpha} \leq 1 \\ 2 & , \quad \sin on \end{cases}$$

$$q = 2$$

### 6.4.3 Flux de cisaillement

La plaque est soumise à un flux de cisaillement uniforme : $-N_{xy}^0$. De ce fait : $N_x^0 = N_y^0 = p_z = 0$. On note que dans ce paragraphe, les formules suivantes sont valides seulement pour Ly<Lx. Dans le cas contraire, certains termes doivent être échangés : $L_x \longleftrightarrow L_y$, et $\Omega_1 \longleftrightarrow \Omega_2$. Le flux de flambage admissible $N_{xy}^c$ s'exprime par :

$$N_{xy}^c = k_s \left(\frac{\pi}{L_y}\right)^2 \sqrt[4]{\Omega_1 \Omega_2^{\ 3}}$$

## Equation 6-24

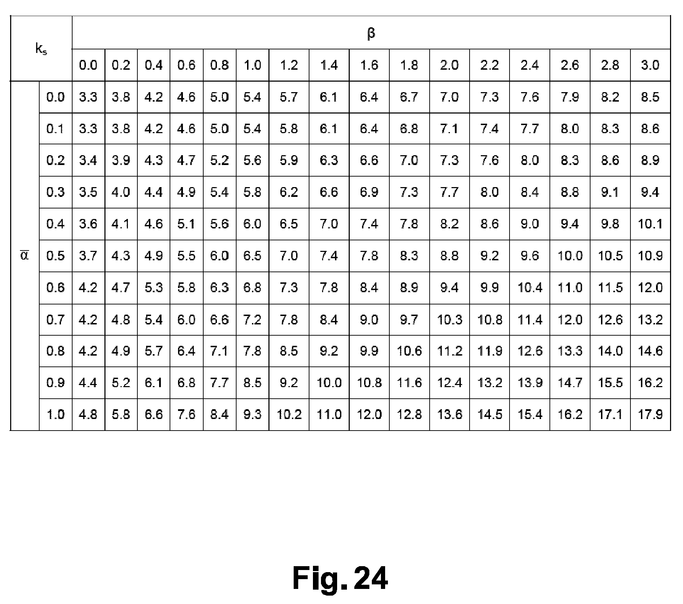

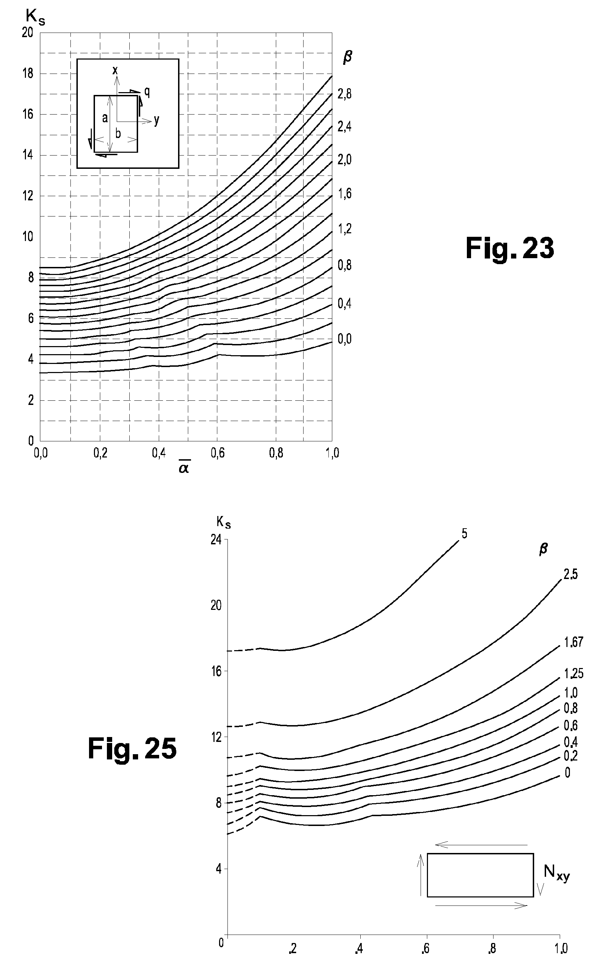

Avec $k_s$ obtenu à partir du graphe de la figure 23 et de la table figure 24 (pour le cas de bords en appui simple), et de la figure 25 (cas de quatre bords encastrés) (source : S. G. Lekhnitskii: Anisotropic Plates. Gordon and Breach).
Les données d'entrée de la table et du graphe sont définies avec:

$$\overline{\alpha} = \frac{L_y}{L_x} \sqrt[4]{\frac{\Omega_1}{\Omega_2}}$$

$$\beta = \frac{\Omega_3}{2\sqrt{\Omega_2 \Omega_1}}$$

### 6.4.4 Flux de compression bi-axiale

La plaque est soumise à un chargement combiné : un flux uniforme de compression longitudinale (selon l'axe x) et un flux uniforme de compression transversal (selon l'axe y) : $-N_{x\,comb}^0$ et $-N_{y\,comb}^0$. De ce fait : $N_{xy}^0 = p_z = 0$. On définit λ par : $N_{y\,comb}^0 = \lambda N_{x\,comb}^0$. L'équation différentielle générale s'exprime

$$-N_{x\,comb}^0 w_{,x^2} - N_{y\,comb}^0 w_{,y^2} = \Omega_1 w_{,x^4} + \Omega_2 w_{,y^4} + \Omega_3 w_{,x^2 y^2}$$

## Equation 6-25

**• Conditions aux limites : quatre bords en appui simple :**

Pour $x$ = 0 et $x$ = $L_x$ : $w$ = 0 et - M$_{xx}$ = 0
Pour $y$ = 0 et $y$ = L$_y$ : $w$ = 0 et $M_{yy}$ = 0

Expression du déplacement:

L'expression suivante du déplacement w satisfait toutes les conditions aux limites détaillées plus haut :

$$w(x, y) = C_{mn} \sin\left(\frac{m\pi x}{L_x}\right) \sin\left(\frac{n\pi y}{L_y}\right) \quad (m, n) \in \mathbf{N}^2$$

# Equation 6-26

<u>Flux de flambage admissibles</u> $\left( N^c_{x\,comb}, N^c_{y\,comb} \right)$ :

L'expression précédente pour w doit satisfaire l'équation différentielle générale (Equation 6-25), et on obtient donc :

$$N^0_{x\,comb}\left(\frac{m\pi}{L_x}\right)^2 + N^0_{y\,comb}\left(\frac{n\pi}{L_y}\right)^2 = \Omega_1\left(\frac{m\pi}{L_x}\right)^4 + \Omega_2\left(\frac{n\pi}{L_y}\right)^4 + \Omega_3\left(\frac{m\pi}{L_x}\right)^2\left(\frac{n\pi}{L_y}\right)^2 \quad (m, n) \in \mathbf{N}^2$$

L'expression de $N^0_{x\,comb}$ fonction de $\lambda$ doit satisfaire :

$$N^0_{x\,comb} = \frac{\pi^2}{L_y{}^2 m^2 + \lambda L_x{}^2 n^2}\left[\Omega_1\left(\frac{L_y}{L_x}\right)^2 m^4 + \Omega_2\left(\frac{L_x}{L_y}\right)^2 n^4 + \Omega_3 m^2 n^2\right] \quad (m, n) \in \mathbf{N}^2$$

ainsi, les flux de flambage admissibles sont obtenus :

$$N^c_{x\,comb} = Min\left\{\frac{\pi^2}{L_y{}^2 m^2 + \lambda L_x{}^2 n^2}\left[\Omega_1\left(\frac{L_y}{L_x}\right)^2 m^4 + \Omega_2\left(\frac{L_x}{L_y}\right)^2 n^4 + \Omega_3 m^2 n^2\right], \quad (m, n) \in \mathbf{N}^2\right\}$$

$$N^c_{y\,comb} = \lambda N^c_{x\,comb}$$

# Equation 6-27

**• Conditions aux limites : quatre bords encastrés :**

Pour $x$ = 0 et $x$ = $L_x$ : $w = 0$ et $\dfrac{\partial w}{\partial y} = 0$

Pour $y$ = 0 et $y$ = $L_y$ : $w = 0$ et $\dfrac{\partial w}{\partial x} = 0$

Expression du déplacement:

L'expression suivante du déplacement w satisfait toutes les conditions aux limites détaillées plus haut :

$$w(x,y) = C_{mn}\left[1 - \cos\left(\frac{m \cdot 2 \cdot \pi \cdot x}{L_x}\right)\right]\left[1 - \cos\left(\frac{n \cdot 2 \cdot \pi \cdot y}{L_y}\right)\right] \quad (m,n) \in \mathbf{N}^2$$

# Equation 6-28

Flux de flambage admissible $(N^c_{x\,comb}, N^c_{y\,comb})$ :

L'expression de $N^0_{x\,comb}$ fonction de $\lambda$ doit satisfaire :

$$N^0_{x\,comb} = \frac{4\pi^2}{L_y^2 m^2 + \lambda L_x^2 n^2}\left[\Omega_1\left(\frac{L_y}{L_x}\right)^2 m^4 + \Omega_2\left(\frac{L_x}{L_y}\right)^2 n^4 + \frac{1}{3}\Omega_3 m^2 n^2\right] \quad (m,n) \in \mathbf{N}^2$$

ainsi, les flux de flambage admissibles sont obtenus :

$$N^c_{x\,comb} = Min\left\{\frac{4\pi^2}{L_y^2 m^2 + \lambda L_x^2 n^2}\left[\Omega_1\left(\frac{L_y}{L_x}\right)^2 m^4 + \Omega_2\left(\frac{L_x}{L_y}\right)^2 n^4 + \frac{1}{3}\Omega_3 m^2 n^2\right], \quad (m,n) \in \mathbf{N}^2\right\}$$

$$N^c_{y\,comb} = \lambda N^c_{x\,comb}$$

# Equation 6-29

### 6.4.5 Flux de compression longitudinale et de cisaillement

La plaque est soumise à des chargement combiné : flux de compression longitudinale uniforme (selon l'axe X) et de cisaillement : $- N^0_{x\,comb}$ et $- N^0_{xy\,comb}$ .

De ce fait: $N^0_y = p_z = 0$ .

**Equation d'interaction:**

L'équation d'interaction pour des flux combinés de compression longitudinale et de cisaillement est :

$$R_x + R_{xy}^{1.75} = 1$$

# Equation 6-30

Avec $R_x = \dfrac{N^c_{x\,comb}}{N^c_x}$ rapport de flux de compression longitudinal $R_{xy} = \dfrac{N^c_{xy\,comb}}{N^c_{xy}}$ rapport de flux de ci-saillement où $N^c_x$ et $N^c_{xy}$ sont les flux de flambage admissibles calculés ci-dessus pour un chargement uni-axial.

**6.4.6 Flux de compression transversale et de cisaillement**

La plaque est soumise à un flux de compression transversale uniforme (selon l'axe y) et à un flux de cisaillement:

$$- N^0_{y\,comb} \quad \text{et} \quad - N^0_{xy\,comb} \,.$$

De ce fait: $N^0_x = p_z = 0$ .

L'équation d'interaction pour les flux combinés de compression transversale et de cisaillement est :

$$R_y + R_{xy}^{\,1.75} = 1$$

## Equation 6-31

Avec :

$$R_y = \frac{N^c_{y\,comb}}{N^c_y} \quad \text{rapport de flux de compression transverse}$$

$$R_{xy} = \frac{N^c_{xy\,comb}}{N^c_{xy}} \quad \text{rapport de flux de cisaillement}$$

où $N^c_y$ et $N^c_{xy}$ sont les flux de flambage admissibles calculés plus haut pour un chargement uni-axial.

**6.4.7 Flux de compression Bi-axiale et de cisaillement**

La plaque est soumise à des chargement combiné : un flux de compression longitudinal uniforme (selon l'axe x) et un flux de compression transversal uniforme (selon l'axe y) en plus d'un flux de cisaillement : $- N^0_{x\,comb}$ , $- N^0_{y\,comb}$ et $- N^0_{xy\,comb}$ .

De ce fait: $p_z = 0$.

L'équation d'interaction est obtenue en deux étapes. D'abord, on détermine un facteur de réserve RF$_{bi}$ correspondant au flux de compression bi-axial :

$$RF_{bi} = \frac{N^c_{x\,comb}}{N^0_{x\,comb}} = \frac{N^c_{y\,comb}}{N^0_{y\,comb}}$$

## Equation 6-32

Puis cette valeur est utilisée dans une équation d'interaction pour des flux combinés de compression bi-axiale et de cisaillement :

$$R_{bi} + R_{xy}^{\,1.75} = 1$$

## Equation 6-33

Avec :

$R_{bi} = RF_{bi}^{-1}$ rapport de flux de compression bi-axial $R_{xy} = \dfrac{N^0_{xy\,comb}}{N^c_{xy}}$ rapport de flux de cisaillement où $N^c_{xy}$ est

le flux de flambage admissible calculé en cisaillement pur.

Le procédé selon l'invention comporte également une boucle d'itération (voir figure 7). Cette boucle permet de modifier les valeurs de charges appliquées, ou les valeurs dimensionnelles des panneaux raidis par des poches triangulaires considérés, selon les résultats de l'une au moins des étapes 3 à 6.

La procédé, tel qu'il a été décrit, peut être mis en oeuvre au moins partiellement sous forme d'une macro sur un logiciel de type tableur. Celle-ci utilise alors, par exemple, comme entrées des données de matériau et de géométrie stockées sur une zone dédiée, ainsi que divers cas de charges considérés, et de conditions aux limites, et fournit en sortie des valeurs de masse du panneau, de facteur de réserve à charge ultime concernant notamment les poches triangulaires, les raidisseurs, l'effondrement général. Ces données de sortie mettent ainsi en évidence les cas de charges ou de dimensionnement incompatibles avec les facteurs de réserve souhaités.

## Avantages de l'invention

On comprend que le procédé NASA antérieurement connu, a été substantiellement étendu dans le cadre de la présente invention pour prendre en compte les spécificités du domaine aéronautique :

- Valeurs locales admissibles pour les raidisseurs (destruction, instabilité latérale etc.) pour la compression selon la direction X ou Y et le cisaillement,
- Valeurs locales admissibles de la peau triangulaire pour la compression selon la direction X ou Y et le cisaillement,
- Correction de plasticité,
- Calcul de masse préliminaire,
- Calcul de flambage général pour une compression selon la direction X ou Y et un cisaillement.

Les améliorations principales sont le calcul des contraintes admissibles pour les différents types de flambage et les calculs des facteurs de réserve adaptés.

Extensions: Cas de chargement

- double-compression (pour le flambage local et global)
- Chargement combiné : compression et cisaillement

Extensions: améliorations des paramètres de la méthode

- Pas de limitation sur le coefficient de Poisson du matériau
- Variation de l'angle de la grille (différent de 60°)
- Plasticité lorsque la structure raidie par des poches triangulaires est considérée comme un panneau équivalent raidi
- Conditions aux limites (attache -"clamping"- ou conditions aux limites intermédiaires) sur le flambage local ou global

Un des avantages les plus significatifs du procédé de dimensionnement selon l'invention est la possibilité d'installer des panneaux raidis par des poches triangulaires, en lieu et place de panneaux précédemment réalisés avec deux familles perpendiculaires de raidisseurs sous ( longerons et traverses), résultant, à résistance mécanique égale, en un gain de masse atteignant 30% sur certaines pièces.

## Variantes de l'invention

La portée de la présente invention ne se limite pas aux détails des formes de réalisation ci-dessus considérées à titre d'exemple, mais s'étend au contraire aux modifications à la portée de l'homme de l'art.

On a cité dans la présente description des angles de base de triangles isocèles compris entre 45° et 70°, qui corresponden t au besoin courant dans les structures aéronautiques. Il est clair cependant qu'un procédé analogue peut être mis en oeuvre pour toute valeur d'angle isocèle dans des panneaux raidis par des poches triangulaires.

## Revendications

1. Procédé de dimensionnement par méthode analytique d'un panneau sensiblement plan en matériau homogène et isotrope, le panneau étant composé d'une peau renforcée par un ensemble (dit "grille") de trois faisceaux parallèles de raidisseurs intégrés au panneau, les poches déterminées sur la peau par ces familles de raidisseurs étant triangulaires, les raidisseurs étant en forme de lame, le panneau raidi devant satisfaire un cahier des charges de résistance mécanique à des charges externes prédéterminées,

**caractérisé en ce que** le procédé comporte les étapes suivantes :

- une première étape d'acquisition de valeurs de données d'entrées relatives à la géométrie du panneau, au matériau et au chargement appliqué à ce panneau,
- une deuxième étape de calcul des contraintes appliquées dans la peau du panneau et les raidisseurs, à partir de la géométrie du panneau raidi par des poches triangulaires, et des charges externes appliquées;
- une troisième étape de calcul des charges internes induites dans les différents composants du panneau raidi;
- une quatrième étape d'analyse de résistance comportant un calcul des facteurs de réserve du matériau à charge limite et à charge ultime,
- une cinquième étape de calcul de contraintes locales admissibles par le panneau, comportant le calcul de facteurs de réserve (RF) à contraintes maximales;
- une sixième étape de calcul d'instabilité générale du panneau comportant le calcul d'un facteur de réserve (RF) pour un panneau plat raidi dans des conditions de chargement pur ou combiné;

les étapes quatre à six étant exécutées de manière indépendante à partir des résultats de l'étape trois, les étapes du procédé étant agencées de façon à être répétées itérativement pour différentes valeurs de données d'entrée jusqu'à l'obtention de facteurs de réserve permettant de déterminer les dimensions et l'agencement des éléments du panneau permettant d'obtenir la résistance mécanique imposée.

2. Procédé selon la revendication 1, **caractérisé en ce que** les données d'entrées de la première étape d'acquisition comportent les paramètres mécaniques relatifs au matériau, les dimensions du panneau, la section droite des raidisseurs, les dimensions de l'âme, l'épaisseur constante du panneau ainsi que les charges aux limites du panneau.

3. Procédé selon l'une des revendications 1 ou 2, **caractérisé en ce que** la troisième étape réalise une correction des charges appliquées pour tenir compte de la plasticité utilisant un procédé de calcul itératif de contraintes plastiques, réalisé jusqu'à ce que les cinq paramètres du matériau ($E_0^{st}$, $E_{+\theta}^{st}$, $E_{-\theta}^{st}$, $E_{peau}$, $\nu_{ep}$) acquis lors de la première étape soient sensiblement égaux aux mêmes paramètres obtenus après calcul de contrainte plastique.

4. Procédé selon l'une des revendications 1 à 3, **caractérisé en ce que** la cinquième étape comporte une étape 5A de calcul de flux de flambage admissible, et de facteur de réserve pour des poches triangulaires isocèles, les contraintes appliquées prises en compte pour le calcul de facteur de réserve étant les contraintes agissant dans la peau uniquement, les flux externes utilisés étant des flux de peau ne correspondant pas au chargement complet du panneau raidi.

5. Procédé selon la revendication 4, **caractérisé en ce que** l'étape 5A comporte deux sous-étapes : une sous-étape de calcul de valeurs admissibles pour des plaques soumises à des cas de chargement pur (compression selon deux directions dans le plan, cisaillement) en utilisant une méthode par éléments finis, puis une sous-étape de calcul des courbes d'interaction entre ces cas de chargement pur.

6. Procédé selon la revendication 5, **caractérisé en ce que** le calcul de valeurs admissibles comporte des sous-étapes suivantes :

• Création d'un modèle paramétrique FEM d'une plaque triangulaire
• Exécution de nombreuses combinaisons différentes pour obtenir des résultats de flambage,
• Obtention de paramètres compatible avec une formulation analytique polynomiale.

7. Procédé selon la revendication 6, **caractérisé en ce que**, dans le cas d'un chargement pur, les courbes d'interaction sont définies par des sous-étapes suivantes :

- de création de modèles éléments finis d'une pluralité de plaques triangulaires présentant des angles isocèles différents, l'angle isocèle ($\theta$) étant défini comme l'angle de base du triangle isocèle,
- pour chaque angle isocèle :

1/ de calcul par Modèle Eléments Finis pour déterminer le flux admissible de plissement (sans correction plastique) pour diverses épaisseurs de plaque.

2/ de tracé d'une courbe de flux de flambage admissible en fonction du rapport $\dfrac{D}{h^2}$ (D raideur de plaque,

h hauteur du triangle), cette courbe étant déterminée pour des petites valeurs du rapport $\dfrac{D}{h^2}$ , par une équation au second degré fonction de ce rapport, dont les coefficients $K_1$ et $K_2$ dépendent de l'angle et du cas de charge considéré,

3/ de tracé de l'évolution des coefficients de l'équation polynomiale $K_1$ et $K_2$ en fonction de l'angle de base du triangle isocèle, ces coefficients étant tracés en fonction de l'angle des plaques triangulaires considérées, et d'interpolation pour déterminer une équation polynomiale qui permet de calculer ces constantes quel que soit l'angle isocèle.

**8.** Procédé selon l'une quelconque des revendications 6 ou 7, **caractérisé en ce que**, dans le cas d'un chargement combiné, on utilise l'hypothèse suivante : si certains composants de la charge combinée sont en tension, alors ces composants ne sont pas pris en compte pour le calcul, et **en ce que** les courbes d'interaction sont définies par des sous-étapes suivantes :

- de création de modèles éléments finis d'une pluralité de plaques triangulaires présentant des angles isocèles différents, l'angle isocèle (θ) étant défini comme l'angle de base du triangle isocèle,
- pour chaque angle,

1/ de calcul par Modèle Eléments Finis (FEM) pour déterminer la valeur propre de flambage correspondant à différentes répartitions de charges externes.
2/ de tracé des courbes d'interaction, pour chaque angle et chaque combinaison de charges, puis d'approximation de ces courbes avec une unique équation couvrant toutes les combinaisons :

$$R_{cX}{}^A + R_{cY}{}^B + R_s{}^C = 1 \ \text{(où } R_i = \dfrac{N_i{}^{app}}{N_i{}^{crit}} \text{ , i = cX, cY ou s), A, B, C étant des coefficients empiriques.}$$

**9.** Procédé selon l'une quelconque des revendications 6 à 8, **caractérisé en ce que**, dans le cas de plaques triangulaires isocèles en appui simple ou encastrées, en cas de chargement combiné, on utilise une courbe d'interaction:

$$R_{cX} + R_{cY} + R_s{}^{\frac{3}{2}} = 1 \, , \ \text{pour tous les cas de chargement.}$$

**10.** Procédé selon l'une quelconque des revendications précédentes, **caractérisé en ce que** l'étape 6, de calcul d'instabilité générale, fournissant des données de flux admissible de flambage, et des facteurs de réserve, pour un panneau plat raidi, dans des conditions de chargement pur ou combiné, le calcul de facteur de réserve, est réalisé à partir des flux externes du panneau raidi et des conditions limites en appui simple ou encastré.

**11.** Produit-programme d'ordinateur comportant une série d'instructions adaptées à mettre en oeuvre un procédé selon l'une quelconque des revendications précédentes, lorsque cette suite d'instructions est exécutée sur un ordinateur.

$L_y$

$L_x$

z

y x

**Fig. 1**

$N_y$

$N_x$

z

y

x

$F_x$

$M_{yy}$

$M_{xx}$

$N_{xy}$

**Fig. 2**

**Fig. 3**

Section A-A

Plan de symétrie
plane

**Fig. 4**

Fig. 5a

Fig. 5b

$F_{cr\_raidisseur}$

$F_{cr.peau}$

distribution de
contraintes supposée

peau

raidisseur

**Fig. 6**

-1.1-Données: géométrie, matériau, charges → -1.2-Calcul de masse

-2- Données appliquées / distribution

-4- Analyse de résistance

MODE DE DEFAUT
R.F matériau

-5- Calcul des admissibles

-5A- Flambage de poche

-5B- Flambage local de raidisseur

-6- instabilité générale

R.F
(facteur de réserve)

R.F
(facteur de réserve)

MODE DE DEFAUT
R.F Général

-Post-flambage de poche

-Post-flambage de raidisseur

**Fig. 7**

**Fig. 8**

**Fig. 9**

**Fig. 10**

Fig. 11

Fig. 12

Fig. 13

| | Conditions aux limites | Formule $k_c$ | Lim | $k_c\infty$ |
|---|---|---|---|---|
| 1 | **Conditions aux limites conservatives**<br>libre<br>ss →→→→ [ ] ←←←← ss<br>ss | $k_c = \left(\dfrac{d}{L_b}\right)^2 + 0.43$ | ∞ | 0.43 |
| 2 | **Lames périphériques "rigides"**<br>libre<br>encastré →→→→ [ ] ←←←← encastré<br>ss | $k_c = 4.143 \cdot \left(\dfrac{d}{L_b}\right)^2 + 0.384$ | 9.49 | 0.43 |
| 3 | **Panneau et lames périphériques "rigides"**<br>libre<br>encastré →→→→ [ ] ←←←← encastré<br>encastré | $k_c = 0.007 \cdot \left(\dfrac{L_b}{d}\right)^2 + 3.923 \cdot \left(\dfrac{d}{L_b}\right)^2 + 0.94$ | 4.34 | 1.28 |
| 4 | **Panneau "rigide"**<br>libre<br>ss →→→→ [ ] ←←←← ss<br>encastré | $k_c = 0.136 \cdot \left(\dfrac{L_b}{d}\right)^2 + 0.987 \cdot \left(\dfrac{d}{L_b}\right)^2 + 0.551$ | 1.64 | 1.28 |

si $\dfrac{L_b}{d} >$ Lim alors $K_c = K_c\infty$

# Fig. 14

**Fig. 15**

**Fig. 16**

## ENTREES

**Charges appliquées**

### Grille de raidisseurs

| Module d'Young des raidisseurs en 3 directions: 0°, +θ, -θ | Angle θ & géométrie |
|---|---|
| $E_{0°}^{st}$ $E_{+\theta}^{st}$ $E_{-\theta}^{st}$ | |

| Matrice [T] | Matrice [Z] |
|---|---|

**Matrice [W]**

### Peau

Données de matériau de peau isotrope

$E_{skin}$

$v_{ep}$

**Matrice [X]**

| Matrice [U] | Matrice [V] |
|---|---|

## RESULTATS

| | Grille de raidisseurs | Peau |
|---|---|---|
| Flux | $N_{xg}$ $N_{yg}$ $N_{xyg}$ | $N_{xs}$ $N_{ys}$ $N_{xys}$ |
| Efforts élastiques | $\sigma_{0°}$ $\sigma_{+\theta}$ $\sigma_{-\theta}$ | $\sigma_{xs}$ $\sigma_{ys}$ $\tau_{xys}$ Von mises: $\sigma_{VMs}$ |
| Correction de plasticité sur les efforts | Correction $\eta_1$ sur les 3 efforts $\eta_1 = \dfrac{E_{scc}}{E_c} \cdot \dfrac{1 - v_e^2}{1 - v^2}$ | Correction $\eta_5$ on $\sigma_{VMs}$ $\eta_5 = \dfrac{E_{tan}}{E}$ |
| Modules d'Young et corfficient de Poisson de la peau corrigés | $E_{0°}^{st\_plast}$ $E_{+\theta}^{st\_plast}$ $E_{-\theta}^{st\_plast}$ | $E_{skin}^{plast}$ $v_{ep}$ |
| Charges dans les raidisseurs | $F_{0°}$ $F_{+\theta}$ $F_{-\theta}$ | |

# Fig. 17

Fig. 18

Fig. 19

Fig. 20

Fig. 21

Fig. 22

| $k_s$ | | β | | | | | | | | | | | | | | | |
|---|---|---|---|---|---|---|---|---|---|---|---|---|---|---|---|---|---|
| | | 0.0 | 0.2 | 0.4 | 0.6 | 0.8 | 1.0 | 1.2 | 1.4 | 1.6 | 1.8 | 2.0 | 2.2 | 2.4 | 2.6 | 2.8 | 3.0 |
| $\overline{\alpha}$ | 0.0 | 3.3 | 3.8 | 4.2 | 4.6 | 5.0 | 5.4 | 5.7 | 6.1 | 6.4 | 6.7 | 7.0 | 7.3 | 7.6 | 7.9 | 8.2 | 8.5 |
| | 0.1 | 3.3 | 3.8 | 4.2 | 4.6 | 5.0 | 5.4 | 5.8 | 6.1 | 6.4 | 6.8 | 7.1 | 7.4 | 7.7 | 8.0 | 8.3 | 8.6 |
| | 0.2 | 3.4 | 3.9 | 4.3 | 4.7 | 5.2 | 5.6 | 5.9 | 6.3 | 6.6 | 7.0 | 7.3 | 7.6 | 8.0 | 8.3 | 8.6 | 8.9 |
| | 0.3 | 3.5 | 4.0 | 4.4 | 4.9 | 5.4 | 5.8 | 6.2 | 6.6 | 6.9 | 7.3 | 7.7 | 8.0 | 8.4 | 8.8 | 9.1 | 9.4 |
| | 0.4 | 3.6 | 4.1 | 4.6 | 5.1 | 5.6 | 6.0 | 6.5 | 7.0 | 7.4 | 7.8 | 8.2 | 8.6 | 9.0 | 9.4 | 9.8 | 10.1 |
| | 0.5 | 3.7 | 4.3 | 4.9 | 5.5 | 6.0 | 6.5 | 7.0 | 7.4 | 7.8 | 8.3 | 8.8 | 9.2 | 9.6 | 10.0 | 10.5 | 10.9 |
| | 0.6 | 4.2 | 4.7 | 5.3 | 5.8 | 6.3 | 6.8 | 7.3 | 7.8 | 8.4 | 8.9 | 9.4 | 9.9 | 10.4 | 11.0 | 11.5 | 12.0 |
| | 0.7 | 4.2 | 4.8 | 5.4 | 6.0 | 6.6 | 7.2 | 7.8 | 8.4 | 9.0 | 9.7 | 10.3 | 10.8 | 11.4 | 12.0 | 12.6 | 13.2 |
| | 0.8 | 4.2 | 4.9 | 5.7 | 6.4 | 7.1 | 7.8 | 8.5 | 9.2 | 9.9 | 10.6 | 11.2 | 11.9 | 12.6 | 13.3 | 14.0 | 14.6 |
| | 0.9 | 4.4 | 5.2 | 6.1 | 6.8 | 7.7 | 8.5 | 9.2 | 10.0 | 10.8 | 11.6 | 12.4 | 13.2 | 13.9 | 14.7 | 15.5 | 16.2 |
| | 1.0 | 4.8 | 5.8 | 6.6 | 7.6 | 8.4 | 9.3 | 10.2 | 11.0 | 12.0 | 12.8 | 13.6 | 14.5 | 15.4 | 16.2 | 17.1 | 17.9 |

# Fig. 24

Fig. 23

Fig. 25

K1 fct° de l'angle

## Fig. 26

K2 fct° de l'angle

## Fig. 27

K1 fct° de l'angle

Fig. 28

K2 fct° de l'angle

Fig. 29

Europäisches
Patentamt

European
Patent Office

Office européen
des brevets

**RAPPORT DE RECHERCHE EUROPEENNE**

Numéro de la demande

EP 16 16 4162

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | CRAIG COLLIER, PHIL YARRINGTON, BARRY VAN WEST: "Composite, Grid-Stiffened Panel Design for Posts Buckling Using Hypersizer", COLLECTION OF TECHNICAL PAPERS - AIAA/ASME/ASCE/AHS/ASC STRUCTURES, STRUCTURAL DYNAMICS AND MATERIALS CONFERNCE, vol. AIAA-2002-1222, 25 avril 2002 (2002-04-25), pages 1-16, XP002580376, * le document en entier * | 1-11 | INV. G06F17/50 |
| Y | VASILIEV V V ET AL: "Anisogrid composite lattice structures for spacecraft and aircraft applications", COMPOSITE STRUCTURES, ELSEVIER SCIENCE LTD, GB LNKD- DOI:10.1016/J.COMPSTRUCT.2006.06.025, vol. 761, no. 1-2, 1 octobre 2006 (2006-10-01), pages 182-189, XP025150611, ISSN: 0263-8223 [extrait le 2006-10-01] * la partie 2. Design * | 1-11 | |

DOMAINES TECHNIQUES
RECHERCHES (IPC)

G06F

-----

-----

-/--

Le présent rapport a été établi pour toutes les revendications

| Lieu de la recherche | Date d'achèvement de la recherche | Examinateur |
|---|---|---|
| Munich | 12 octobre 2016 | Lerbinger, Klaus |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons

& : membre de la même famille, document correspondant

EPO FORM 1503 03.82 (P04C02)

Europäisches
Patentamt

European
Patent Office

Office européen
des brevets

## RAPPORT DE RECHERCHE EUROPEENNE

Numéro de la demande

EP 16 16 4162

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | AKL W ET AL: "Optimization of the static and dynamic characteristics of plates with isogrid stiffeners", FINITE ELEMENTS IN ANALYSIS AND DESIGN, ELSEVIER, AMSTERDAM, NL LNKD-DOI:10.1016/J.FINEL.2008.01.015, vol. 44, no. 8, 1 mai 2008 (2008-05-01), pages 513-523, XP022622025, ISSN: 0168-874X [extrait le 2008-03-07] * le documen en entier, en particulier : Fig. 8; page 519, point 3. ; la partie 5. Conclusions * ----- | 1-11 | |
| A | US 2004/055349 A1 (EL-SOUDANI SAMI M [US]) 25 mars 2004 (2004-03-25) * alinéa [0033] - alinéa [0034] * ----- | 1-11 | |
| | | | **DOMAINES TECHNIQUES RECHERCHES (IPC)** |

Le présent rapport a été établi pour toutes les revendications

| Lieu de la recherche | Date d'achèvement de la recherche | Examinateur |
|---|---|---|
| Munich | 12 octobre 2016 | Lerbinger, Klaus |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 16 16 4162

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

12-10-2016

| Document brevet cité au rapport de recherche | Date de publication | Membre(s) de la famille de brevet(s) | | Date de publication |
|---|---|---|---|---|
| US 2004055349 A1 | 25-03-2004 | AU | 2003268301 A1 | 19-04-2004 |
| | | US | 2004055349 A1 | 25-03-2004 |
| | | WO | 2004028719 A1 | 08-04-2004 |

EPO FORM P0460

Pour tout renseignement concernant cette annexe : voir Journal Officiel de l'Office européen des brevets, No.12/82